# EUROPEAN PATENT APPLICATION

(11) **EP 4 593 002 A1**
(43) Date of publication of application: **30.07.2025**
(21) Application number: 24223444.1
(22) Date of filing: 27.12.2024
(51) Int. Cl.: G09G 3/3266

(54) **GATE DRIVER, DISPLAY DEVICE INCLUDING THE GATE DRIVER, AND ELECTRONIC DEVICE INCLUDING THE DISPLAY DEVICE**

(30) Priority: 29.01.2024 KR 20240013304
(71) Applicant: Samsung Display Co., Ltd., Yongin-si, Gyeonggi-do 17113 (KR)
(72) Inventor: KEUM, Nackhyeon, 17113 Yongin-si (KR); KIM, Taegyun, 17113 Yongin-si (KR); JEONG, Minjae, 17113 Yongin-si (KR); KOO, Bon-Yong, 17113 Yongin-si (KR); MOON, Geumju, 17113 Yongin-si (KR); LEE, Kwangsae, 17113 Yongin-si (KR)
(74) Representative: Taor, Simon Edward William

(57) **Abstract**

A gate driver includes: a plurality of stages. Each of the stages includes: a control circuit configured to control a voltage of a first node and a voltage of a second node in response to an input signal, a first clock signal, and a second clock signal; and a gate output circuit configured to output a gate signal in response to the voltage of the first node and the voltage of the second node. The control circuit includes a first control switching element configured to selectively connect the first node and the gate output circuit in response to an enable signal.

## Description

### BACKGROUND

### 1. Field

Embodiments of the present invention relates to a gate driver, a display device including the gate driver, and an electronic device including the display device. More particularly, the present invention relates to a gate driver, a display device including the gate driver, and an electronic device including the display device for reducing a power consumption.

### 2. Description of the Related Art

In general, a display device includes a display panel and a display panel driver. The display panel includes gate lines, data lines, emission lines, and pixels. The display panel driver includes a gate driver for providing a gate signal to the gate lines, a data driver for providing a data voltage to the data lines, an emission driver for providing an emission signal to the emission lines, and a driving controller for controlling the gate driver, the data driver, and the emission driver.

Recently, it has been demanded to reduce the power consumption of the display device, and in particular, it has been demanded to reduce the power consumption of the display device in a mobile device such as a smart phone and a tablet computer. In order to reduce the power consumption of the display device, a low-frequency driving technology, which drives at a low frequency lower than a general driving frequency or refreshes the display panel, has been developed.

Meanwhile, in a conventional display device to which the low-frequency driving technology is applied, when a still image is not displayed in an entire area of the display panel, that is, when the still image is displayed only in a part of the display panel, the entire area of the display panel is driven at the general driving frequency. Therefore, in this case, a low-frequency driving is not performed, and the power consumption is not reduced.

### SUMMARY

Embodiments of the present invention provide a gate driver for supporting a driving frequency multi-division to reduce a power consumption of a display device.

Embodiments of the present invention provide a display device including the gate driver.

Embodiments of the present invention provide an electronic device device including the display device.

In an embodiment of a gate driver according to the present invention, the gate driver includes a plurality of stages. Each of the stages includes: a control circuit configured to control a voltage of a first node and a voltage of a second node in response to an input signal, a first clock signal, and a second clock signal; and a gate output circuit configured to output a gate signal in response to the voltage of the first node and the voltage of the second node. The control circuit includes a first control switching element configured to selectively connect the first node and the gate output circuit in response to an enable signal.

In an embodiment, the gate output circuit may be configured to selectively output the gate signal in response to the enable signal.

In an embodiment, when the enable signal has an inactive level which turns off the first control switching element before the input signal has a high level, a gate signal having a low level may be output, and when the enable signal has the inactive level after the input signal has the high level, a gate signal having the high level may be output.

In an embodiment, when the enable signal has an inactive level which turns off the first control switching element before the input signal has a low level, a gate signal having a high level may be output, and when the enable signal has the inactive level after the input signal has the low level, a gate signal having the low level may be output.

In an embodiment, the gate signal may be at least one of a data writing gate signal, a compensation gate signal, and a data initialization gate signal which are applied to the pixel, and a data voltage may be applied to the pixel in response to the data writing gate signal, a threshold voltage of a driving transistor included in the pixel may be compensated in response to the compensation gate signal, and the driving transistor may be initialized in response to the data initialization gate signal.

In an embodiment, the pixel may include a first transistor, which is the driving transistor, including a gate electrode connected to a first pixel node, a first electrode connected to a second pixel node, and a second electrode connected to a third pixel node, a second transistor including a gate electrode to which the data writing gate signal is applied, a first electrode to which the data voltage is applied, and a second electrode connected to the second pixel node, a third transistor including a gate electrode to which the compensation gate signal is applied, a first electrode connected to the first pixel node, and a second electrode connected to the third pixel node, a fourth transistor including a gate electrode to which the data initialization gate signal is applied, a first electrode to which an initialization voltage is applied, and a second electrode connected to the first pixel node, a fifth transistor including a gate electrode to which an emission signal is applied, a first electrode to which a first driving voltage is applied, and a second electrode connected to the second pixel node, a seventh transistor including a gate electrode to which a light-emitting element initialization gate signal is applied, a first electrode to which a light-emitting element initialization voltage is applied, and a second electrode connected to an anode electrode of a light-emitting element, and the light-emitting element including the anode electrode and a cathode electrode to which a second driving voltage is applied.

In an embodiment, the first control switching element may include a gate electrode configured to receive the enable signal, a first electrode connected to a third node, and a second electrode connected to a fifth node, and the control circuit may further include a first switching element including a gate electrode configured to receive the first clock signal, a first electrode configured to receive the input signal, and a second electrode connected to the third node, a second switching element including a gate electrode connected to the first node, a first electrode configured to receive the second clock signal, and a second electrode connected to a fourth node, a ninth switching element including a gate electrode configured to receive a gate low voltage, a first electrode connected to the fifth node, and a second electrode connected to the first node, and a third capacitor including a first electrode connected to the fourth node and a second electrode connected to the first node.

In an embodiment, the control circuit may further include a third switching element including a gate electrode configured to receive the first clock signal, a first electrode configured to receive the gate low voltage, and a second electrode connected to a sixth node, a fourth switching element including a gate electrode configured to receive the gate low voltage, a first electrode connected to the sixth node, and a second electrode connected to a seventh node, a fifth switching element including a gate electrode connected to the first node, a first electrode configured to receive the first clock signal, and a second electrode connected to the sixth node, a sixth switching element including a gate electrode connected to the seventh node, a first electrode configured to receive the second clock signal, and a second electrode connected to an eighth node, a seventh switching element including a gate electrode configured to receive the second clock signal, a first electrode connected to the eighth node, and a second electrode connected to the second node, an eighth switching element including a gate electrode connected to the first node, a first electrode configured to receive the first clock signal, and a second electrode connected to the second node, a first capacitor including a first electrode configured to receive the first clock signal and a second electrode connected to the second node, and a second capacitor including a first electrode connected to the seventh node and a second electrode connected to the eighth node.

In an embodiment, the gate output circuit may include: a tenth switching element including a gate electrode connected to the second node, a first electrode configured to receive the first clock signal, and a second electrode connected to a gate output node; and an eleventh switching element including a gate electrode connected to the first node, a first electrode configured to receive the gate low voltage, and a second electrode connected to the gate output node.

In an embodiment, the control circuit may include: a first switching element including a gate electrode configured to receive the first clock signal, a first electrode configured to receive the input signal, and a second electrode connected to a third node, and the gate output circuit may further include a seventh switching element including a gate electrode connected to the second node, a first electrode configured to receive a gate high voltage, and a second electrode connected to a gate output node and an eighth switching element including a gate electrode connected to the first node, a first electrode configured to receive the second clock signal, and a second electrode connected to the gate output node.

In an embodiment, the first control switching element may include a gate electrode configured to receive the enable signal, a first electrode connected to a fifth node, and a second electrode connected to the first node.

In an embodiment, the control circuit may further include a sixth switching element including a gate electrode configured to receive a gate low voltage, a first electrode connected to the third node, and a second electrode connected to the fifth node.

In an embodiment, the control circuit may further include a second switching element including a gate electrode connected to the second node, a first electrode configured to receive the gate high voltage, and a second electrode connected to a fourth node, a third switching element including a gate electrode configured to receive the second clock signal, a first electrode connected to the fourth node, and a second electrode connected to the third node, a fourth switching element including a gate electrode configured to receive the first clock signal, a first electrode configured to receive the gate low voltage, and a second electrode connected to the second node, and a fifth switching element including a gate electrode connected to the third node, a first electrode configured to receive the first clock signal, and a second electrode connected to the second node, and the gate output circuit may further include a first capacitor including a first electrode connected to the first node and a second electrode connected to the gate output node and a second capacitor including a first electrode configured to receive the gate high voltage and a second electrode connected to the second node.

In an embodiment, the first control switching element may have a dual transistor structure including two transistors.

In an embodiment, the first control switching element may be an N-type transistor.

In an embodiment, the control circuit may further include a second control switching element configured to selectively connect the second node and the gate output circuit in response to the enable signal.

In an embodiment, the control circuit may further include a first switching element including a gate electrode configured to receive the first clock signal, a first electrode configured to receive the input signal, and a second electrode connected to a third node, and the gate output circuit may include a seventh switching element including a gate electrode connected to the second node, a first electrode configured to receive the gate high voltage, and a second electrode connected to a gate output node and an eighth switching element including a gate electrode connected to the first node, a first electrode configured to receive the second clock signal, and a second electrode connected to the gate output node.

In an embodiment, the first control switching element may include a gate electrode configured to receive the enable signal, a first electrode connected to a fifth node, and a second electrode connected to the first node.

In an embodiment, the second control switching element may include a gate electrode configured to receive the enable signal, a first electrode connected to a sixth node, and a second electrode connected to the second node.

In an embodiment, the control circuit may further include a sixth switching element including a gate electrode configured to receive a gate low voltage, a first electrode connected to the third node, and the second electrode connected to the fifth node.

In an embodiment, the control circuit may further include a second switching element including a gate electrode connected to the sixth node, a first electrode configured to receive the gate high voltage, and a second electrode connected to the fourth node, a third switching element including a gate electrode configured to receive the second clock signal, the first electrode connected to the fourth node, and a second electrode connected to the third node, a fourth switching element including a gate electrode configured to receive the first clock signal, a first electrode configured to receive the gate low voltage, and a second electrode connected to the sixth node, and a fifth switching element including a gate electrode connected to the third node, a first electrode configured to receive the first clock signal, and a second electrode connected to the sixth node, and the gate output circuit may further include a first capacitor including a first electrode connected to the first node and a second electrode connected to the gate output node and a second capacitor including a first electrode configured to receive the gate high voltage and a second electrode connected to the second node.

In an embodiment, the control circuit may include a first switching element including a gate electrode configured to receive the first clock signal, a first electrode configured to receive the input signal, and a second electrode connected to a third node, and the gate output circuit may include a ninth switching element including a gate electrode connected to the second node, a first electrode configured to receive a gate high voltage, and a second electrode connected to a gate output node and a tenth switching element including a gate electrode connected to the first node, a first electrode configured to receive a gate low voltage, and a second electrode connected to the gate output node.

In an embodiment, the first control switching element may include a gate electrode configured to receive the enable signal, a first electrode connected to the third node, and a second electrode connected to the first node.

In an embodiment, the second control switching element may include a gate electrode configured to receive the enable signal, a first electrode connected to a seventh node, and a second electrode connected to the second node.

In an embodiment, the control circuit may include a second switching element including a gate electrode connected to a fifth node, a first electrode configured to receive the gate high voltage, and a second electrode connected to a fourth node, a third switching element including a gate electrode configured to receive the second clock signal, a first electrode connected to the fourth node, and a second electrode connected to the third node, a fourth switching element including a gate electrode configured to receive the first clock signal, a first electrode configured to receive the gate low voltage, and a second electrode connected to the fifth node, a fifth switching element including a gate electrode configured to receive the second clock signal, a first electrode connected to a sixth node, and a second electrode connected to the seventh node, a sixth switching element including a gate electrode connected to the fifth node, a first electrode configured to receive the second clock signal, and a second electrode connected to the sixth node, a seventh switching element including a gate electrode connected to the third node, a first electrode configured to receive the gate high voltage, and a second electrode connected to the second node, an eighth switching element including a gate electrode connected to the third node, a first electrode configured to receive the first clock signal, and a second electrode connected to the fifth node, a first capacitor including a first electrode configured to receive the second clock signal and a second electrode connected to the third node, a second capacitor including a first electrode connected to the fifth node and a second electrode connected to the sixth node, and a third capacitor including a first electrode configured to receive the gate high voltage and a second electrode connected to the seventh node.

In an embodiment of a display device according to the present invention, the display device includes: a display panel including a plurality of pixels, a gate driver configured to apply a gate signal to the display panel, and a data driver configured to apply a data voltage to the display panel. The gate driver includes a plurality of stages, and each of each of the stages includes a control circuit configured to control a voltage of a first node and a voltage of a second node in response to an input signal, a first clock signal, and a second clock signal and a gate output circuit configured to output the gate signal in response to the voltage of the first node and the voltage of the second node. The control circuit includes a first control switching element configured to selectively connect the first node and the gate output circuit in response to an enable signal.

In embodiment, the gate output circuit may be configured to selectively output the gate signal in response to the enable signal.

In embodiment, when the enable signal has an inactive level which turns off the first control switching element before the input signal has a high level, a gate signal having a low level may be output, and when the enable signal has the inactive level after the input signal has the high level, a gate signal having the high level may be output.

In embodiment, when the enable signal has an inactive level which turns off the first control switching element before the input signal has a low level, a gate signal having a high level may be output, and when the enable signal has the inactive level after the input signal has the low level, a gate signal having the low level may be output.

In an embodiment of a, electronic device according to the present invention, the electronic device includes: a display panel including a plurality of pixels, a gate driver configured to apply a gate signal to the display panel, a data driver configured to apply a data voltage to the display panel, a driving controller configured to control the gate driver and the data driver, and a processor configured to apply input image data to the driving controller. The gate driver includes a plurality of stages, and each of each of the stages includes a control circuit configured to control a voltage of a first node and a voltage of a second node in response to an input signal, a first clock signal, and a second clock signal and a gate output circuit configured to output the gate signal in response to the voltage of the first node and the voltage of the second node. The control circuit includes a first control switching element configured to selectively connect the first node and the gate output circuit in response to an enable signal.

According to an aspect, there is provided a gate driver as set out in claim 1. Additional features are set out in claims 2 to 13.

According to an aspect, there is provided a display device as set out in claim 14.

According to an aspect, there is provided an electronic device as set out in claim 15.

According to the gate driver, the display device, and the electronic device, a gate driver and a display device may include a control circuit and a gate output circuit, and the control circuit may include a first control switching element configured to selectively connect a first node and the gate output circuit in response to an enable signal, such that a driving frequency multi-division may be supported. Through the driving frequency multi-division, a power consumption of the display device may be effectively reduced.

### BRIEF DESCRIPTION OF THE DRAWINGS

The above and other features of embodiments of the present invention will become more apparent by describing in detailed embodiments thereof with reference to the accompanying drawings, in which:
FIG. 1 is a block diagram showing a display device according to embodiments of the present invention;
FIG. 2 is a conceptual diagram describing a driving frequency of a display panel of FIG. 1;
FIG. 3 is a circuit diagram showing an example of a pixel of a display panel of FIG. 1;
FIG. 4 is a timing diagram showing a driving signal of a pixel of FIG. 3 in a variable frequency drive;
FIG. 5 is a conceptual diagram showing a gate driver of FIG. 1;
FIG. 6 is a conceptual diagram showing a driving frequency for each area of a display panel of FIG. 1 in a multi-frequency driving;
FIG. 7 is a conceptual diagram showing each stage included in a gate driver of FIG. 6;
FIG. 8 is a circuit diagram showing an example of each stage of FIG. 7;
FIG. 9 is a timing diagram showing an input signal, a first clock signal, a second clock signal, node signals, an enable signal, and an output signal of each stage of FIG. 8 when the enable signal has an active level;
FIG. 10 is a circuit diagram showing an operation of each stage of FIG. 8 in a first time period of FIG. 9;
FIG. 11 is a circuit diagram showing an operation of each stage of FIG. 8 in a second time period of FIG. 9;
FIG. 12 is a circuit diagram showing an operation of each stage of FIG. 8 in a third time period of FIG. 9;
FIG. 13 is a circuit diagram showing an operation of each stage of FIG. 8 in a fourth time period of FIG. 9;
FIG. 14 is a circuit diagram showing an operation of each stage of FIG. 8 in a fifth time period of FIG. 9;
FIG. 15 is a circuit diagram showing an operation of each stage of FIG. 8 in a sixth time period of FIG. 9;
FIG. 16 is a circuit diagram showing an operation of each stage of FIG. 8 in a seventh time period of FIG. 9;
FIG. 17 is a circuit diagram showing an operation of each stage of FIG. 8 in an eighth time period of FIG. 9;
FIG. 18 is a timing diagram showing an input signal, a first clock signal, a second clock signal, node signals, and an output signal of each stage of FIG. 8 when an enable signal has an inactive level;
FIG. 19 is a circuit diagram showing an operation of each stage of FIG. 8 in a first time period of FIG. 18;
FIG. 20 is a circuit diagram showing an operation of each stage of FIG. 8 in a second time period of FIG. 18;
FIG. 21 is a circuit diagram showing an operation of each stage of FIG. 8 in a third time period of FIG. 18;
FIG. 22 is a circuit diagram showing an operation of each stage of FIG. 8 in a fourth time period of FIG. 18;
FIG. 23 is a circuit diagram showing an operation of each stage of FIG. 8 in a fifth time period of FIG. 18;
FIG. 24 is a circuit diagram showing another example of each stage of FIG. 7;
FIG. 25 is a timing diagram showing an input signal, a first clock signal, a second clock signal, node signals, and an output signal of each stage of FIG. 24;
FIG. 26 is a circuit diagram showing an operation of each stage of FIG. 24 in a first time period of FIG. 25;
FIG. 27 is a circuit diagram showing an operation of each stage of FIG. 24 in a second time period of FIG. 25;
FIG. 28 is a circuit diagram showing an operation of each stage of FIG. 24 in a third time period of FIG. 25;
FIG. 29 is a circuit diagram showing an operation of each stage of FIG. 24 in a fourth time period of FIG. 25;
FIG. 30 is a circuit diagram showing an operation of each stage of FIG. 24 in a fifth time period of FIG. 25;
FIG. 31 is a circuit diagram showing an operation of each stage of FIG. 24 when an enable signal has an inactive level;
FIG. 32 is a circuit diagram showing still another example of each stage of FIG. 7;
FIG. 33 is a circuit diagram showing yet another example of each stage of FIG. 7;
FIG. 34 is a circuit diagram showing still another example of each stage of FIG. 7;
FIG. 35 is a circuit diagram showing yet another example of each stage of FIG. 7;
FIG. 36 is a timing diagram showing an input signal, a first clock signal, a second clock signal, node signals, and an output signal of each stage of FIG. 35;
FIG. 37 is a circuit diagram showing an operation of each stage of FIG. 35 in a first time period of FIG. 36;
FIG. 38 is a circuit diagram showing an operation of each stage of FIG. 35 in a second time period of FIG. 36;
FIG. 39 is a circuit diagram showing an operation of each stage of FIG. 35 in a third time period of FIG. 36;
FIG. 40 is a circuit diagram showing an operation of each stage of FIG. 35 when an enable signal has an inactive level;
FIG. 41 is a block diagram showing an electronic device; and
FIG. 42 is a diagram showing an embodiment in which an electronic device of FIG. 41 is implemented as a smart phone.

### DETAILED DESCRIPTION

The terminology used herein is for the purpose of describing particular embodiments only and is not intended to be limiting. As used herein, "a", "an," "the," and "at least one" do not denote a limitation of quantity and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein. Hereinafter, the present invention will be described in more detail with reference to the accompanying drawings.

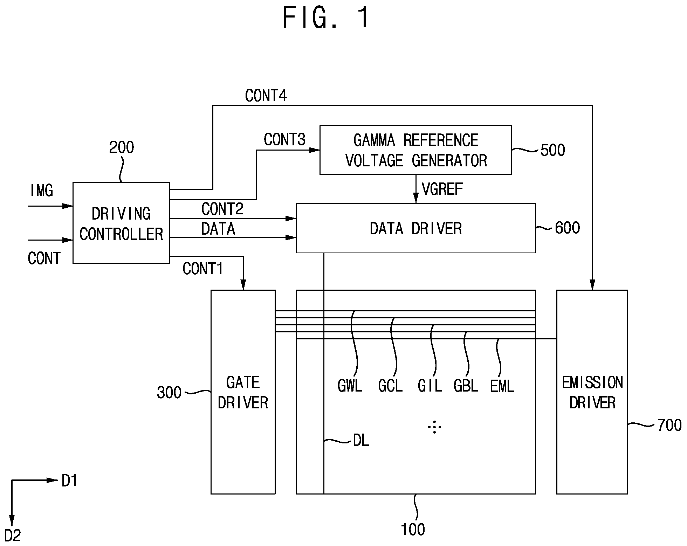

FIG. 1 is a block diagram showing a display device according to embodiments of the present invention.

Referring to FIG. 1, a display device may include a display panel 100 and a display panel driver. The display panel driver may include a driving controller 200, a gate driver 300, a gamma reference voltage generator 500, a data driver 600, and an emission driver 700.

The display panel 100 may include a display area for displaying an image and a peripheral area disposed adjacent to the display area.

The display panel 100 may include gate lines GWL, GCL, GIL, GBL, data lines DL, emission lines EML and pixels electrically connected to the gate lines GWL, GCL, GIL, GBL, the data lines DL, and the emission lines EML, respectively. The gate lines GWL, GCL, GIL, GBL may extend in a first direction D1, the data lines DL may extend in a second direction D1 crossing the first direction D1, and the emission lines EML may extend in the first direction D1.

The driving controller 200 may receive input image data IMG and an input control signal CONT from an external device. For example, the input image data IMG may include red image data, green image data and blue image data. The input image data IMG may include white image data. The input image data IMG may include magenta image data, yellow image data, and cyan image data. The input control signal CONT may include a master clock signal and a data enable signal. The input control signal CONT may further include a vertical synchronization signal and a horizontal synchronization signal.

The driving controller 200 may generate a first control signal CONT1, a second control signal CONT2, a third control signal CONT3, a fourth control signal CONT4 and a data signal DATA based on the input image data IMG and the input control signal CONT.

The driving controller 200 may generate the first control signal CONT1 for controlling an operation of the gate driver 300 based on the input control signal CONT, and output the first control signal CONT1 to the gate driver 300. The first control signal CONT1 may include a vertical start signal and a gate clock signal.

The driving controller 200 may generate the second control signal CONT2 for controlling an operation of the data driver 600 based on the input control signal CONT, and output the second control signal CONT2 to the data driver 600. The second control signal CONT2 may include a horizontal start signal and a load signal.

The driving controller 200 may generate the data signal DATA based on the input image data IMG. The driving controller 200 may output the data signal DATA to the data driver 600.

The driving controller 200 may generate the third control signal CONT3 for controlling an operation of the gamma reference voltage generator 500 based on the input control signal CONT, and output the third control signal CONT3 to the gamma reference voltage generator 500.

The driving controller 200 may generate the fourth control signal CONT4 for controlling an operation of the emission driver 700 based on the input control signal CONT, and output the fourth control signal CONT4 to the emission driver 700.

The gate driver 300 may generate gate signals for driving the gate lines GWL, GCL, GIL, GBL in response to the first control signal CONT1 received from the driving controller 200. The gate driver 300 may output the gate signals to the gate lines GWL, GCL, GIL, GBL.

The gamma reference voltage generator 500 may generate a gamma reference voltage VGREF in response to the third control signal CONT3 received from the driving controller 200. The gamma reference voltage generator 500 may provide the gamma reference voltage VGREF to the data driver 600. The gamma reference voltage VGREF may have a value corresponding to each data signal DATA.

For example, the gamma reference voltage generator 500 may be disposed in the driving controller 200 or may be disposed in the data driver 600.

The data driver 600 may receive the second control signal CONT2 and the data signal DATA from the driving controller 200, and receive the gamma reference voltage VGREF from the gamma reference voltage generator 500. The data driver 600 may convert the data signal DATA into a data voltage having an analog type using the gamma reference voltage VGREF. The data driver 600 may output the data voltage to the data line DL.

The emission driver 700 may generate emission signals for driving the emission lines EML in response to the fourth control signal CONT4 received from the driving controller 200. The emission driver 700 may output the emission signals to the emission lines EML.

In FIG. 1, for a convenience of an explanation, the gate driver 300 may be disposed on a first side of the display panel 100 and the emission driver 700 may be disposed on a second side of the display panel 100. Although shown, embodiments of the present invention are not limited thereto. For another example, both the gate driver 300 and the emission driver 700 may be disposed on the first side of the display panel 100. For example, both the gate driver 300 and the emission driver 700 may be disposed on opposite sides of the display panel 100. For example, the gate driver 300 and the emission driver 700 may be formed integrally.

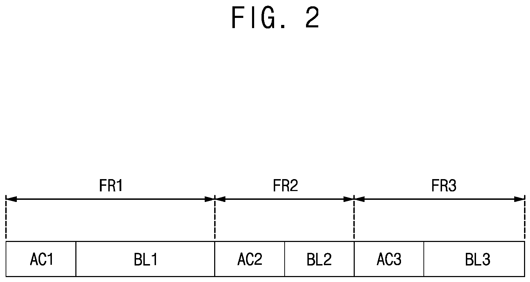

FIG. 2 is a conceptual diagram describing a driving frequency of a display panel 100 of FIG. 1.

Referring to FIG. 1 and FIG. 2, the display panel 100 may be driven at a variable frequency. A first frame FR1 having a first frequency may include a first active period AC1 and a first blank period BL1. A second frame FR2 having a second frequency different from the first frequency may include a second active period AC2 and a second blank period BL2. A third frame FR3 having a third frequency different from the first frequency and the second frequency may include a third active period AC3 and a third blank period BL3.

The first active period AC1 may have the same length as the second active period AC2, and the first blank period BL1 may have a different length from the second blank period BL2. The second active period AC2 may have the same length as the third active period AC3, and the second blank period BL2 may have a different length from the third blank period BL3.

A display device supporting a variable frequency may include a data writing period in which a data voltage is written to a pixel and a self-scan period in which the data voltage is not written to the pixel and a light is only emitted. The data writing period may be arranged within the active period AC1, AC2, AC3. The self-scan period may be arranged within the blank period BL1, BL2, BL3.

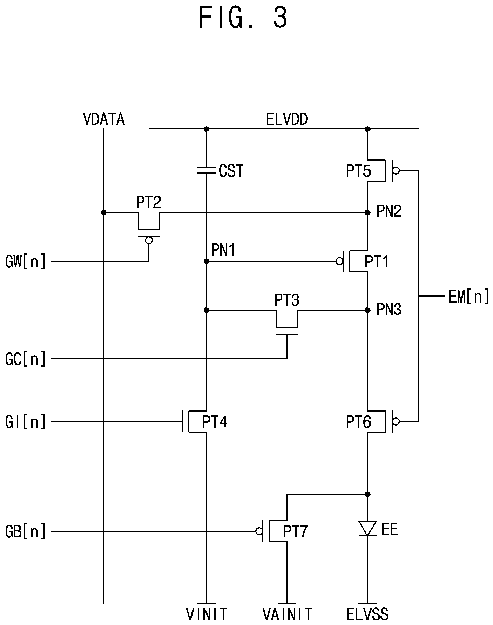

FIG. 3 is a circuit diagram showing an example of a pixel of a display panel 100 of FIG. 1.

Referring to Figs. 1 to 3, the display panel 100 includes the pixels, and each of the pixels includes a light-emitting element EE.

The pixels may receive a data writing gate signal GW[n], a compensation gate signal GC[n], a data initialization gate signal GI[n], a light-emitting element initialization gate signal GB[n], the data voltage VDATA, and the emission signal EM[n], and may display the image by emitting the light-emitting element EE according to a level of the data voltage VDATA.

In an embodiment, the pixels may include a first type of a switching element and a second type of a switching element different from the first type. For example, the first type of the switching element may be a P-type transistor, and the second type of the switching element may be an N-type transistor. For example, the first type of the switching element may be a polysilicon thin film transistor. For example, the first type of the switching element may be a low temperature polysilicon LTPS thin film transistor. For example, the second type of the switching element may be an oxide thin film transistor. At least one of the pixels may include first to seventh transistors PT1 to PT7 and the light-emitting element EE.

The first transistor PT1 (i.e., a driving transistor) may include a gate electrode connected to a first pixel node PN1, a first electrode connected to a second pixel node PN2, and a second electrode connected to a third pixel node PN3.

The second transistor PT2 may include a gate electrode to which the data writing gate signal GW[n] is applied, a first electrode to which the data voltage VDATA is applied, and a second electrode connected to the second pixel node PN2. The data voltage VDATA may be applied to the pixel in response to the data writing gate signal GW[n],

The third transistor PT3 may include a gate electrode to which the compensation gate signal GC[n] is applied, a first electrode connected to the first pixel node PN1, and a second electrode connected to the third pixel node PN3. The threshold voltage of the first transistor PT1 may be compensated in response to the compensation gate signal GC[n],

The fourth transistor PT4 may include a gate electrode to which the data initialization gate signal GI[n] is applied, a first electrode to which the initialization voltage VINIT is applied, and a second electrode connected to the first pixel node PN1. The gate electrode of the first transistor PT1 may be initialized to the initialization voltage VINIT in response to the data initialization gate signal GI[n],

The fifth transistor PT5 may include a gate electrode to which the emission signal EM[n] is applied, a first electrode to which a first driving voltage ELVDD is applied, and a second electrode connected to the second pixel node PN2.

The sixth transistor PT6 may include a gate electrode to which the emission signal EM[n] is applied, a first electrode connected to the third pixel node PN3, and a second electrode connected to an anode electrode of the light-emitting element EE.

The seventh transistor PT7 may include a gate electrode to which the light-emitting element initialization gate signal GB[n] is applied, a first electrode to which the light-emitting element initialization voltage VAINIT is applied, and a second electrode connected to the anode electrode of the light-emitting element EE.

The light-emitting element EE may include the anode electrode and a cathode electrode to which the second driving voltage ELVSS is applied.

The pixel may further include a storage capacitor CST including a first electrode to which the first driving voltage ELVDD is applied and a second electrode connected to the first pixel node PN1.

A signal output from a gate output circuit of the gate driver 300 may be the data writing gate signal GW[n], the compensation gate signal GC[n], the data initialization gate signal GI[n], or the light-emitting element initialization gate signal GB[n],

A driving current of the pixel may flow in an order of the fifth transistor PT5, the first transistor PT1, and the sixth transistor PT6 to drive the light-emitting element EE. An intensity of the driving current may be determined by a level of the data voltage VDATA. A brightness of the light-emitting element EE may be determined by the intensity of the driving current.

A leakage current may be generated more in the P-type transistor than in the N-type transistor. Therefore, some of the transistors included in the pixel may be the N-type transistors. In an embodiment, the third transistor PT3 and the fourth transistor PT4 transistors may be the N-type transistors. The first transistor PT1, the second transistor PT2, the fifth transistor PT5, the sixth transistor PT6, and the seventh transistor PT7 may be the P-type transistors.

In this embodiment, it is exemplified that some of the switching elements of the pixel are the N-type transistors and other some of the switching elements are the P-type transistors, but embodiments of the present invention are not limited thereto. The present invention may be applied to a pixel including only the P-type transistors in another embodiment. In addition, the present invention may be applied to a pixel including only the N-type transistors in still another embodiment.

When a signal applied to a gate electrode of a switching element has an active level, the switching element may be turned on. When the signal applied to the gate electrode of the switching element has an inactive level, the switching element may be turned off. The active level means a level at which the switching element is turned on, and the inactive level means a level at which the switching element is turned off. When the switching element is the P-type transistor, the active level may be a low level and the inactive level may be a high level. When the switching element is the N-type transistor, the active level may be the high level and the inactive level may be the low level.

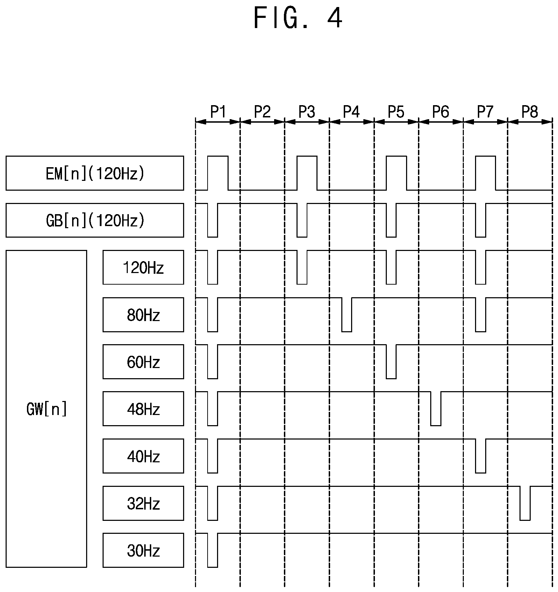

FIG. 4 is a timing diagram showing a driving signal of a pixel of FIG. 3 in a variable frequency drive.

Referring to FIG. 4, the display panel 100 may be driven at a variable frequency. For example, the display panel 100 may be driven at a maximum of 120 Hz. When the display panel 100 is driven at 120 Hz, in a first period P1, a third period P3, a fifth period P5, and a seventh period P7, the data writing gate signal GW[n] may have an active pulse and a data writing operation may be performed. When the display panel 100 is driven at 60 Hz, in the first period P1 and the fifth period P5, the data writing gate signal GW[n] may have the active pulse and the data writing operation may be performed.

When the display panel 100 is driven at 120 Hz, in the first period P1, the third period P3, the fifth period P5, and the seventh period P7, the emission signal EM[n] may have the active pulse, and a light-emitting operation may be performed. When the display panel 100 is driven at 60 Hz, in the first period P1, the third period P3, the fifth period P5, and the seventh period P7, the emission signal EM[n] may have the active pulse, and the light-emitting operation may be performed.

When the display panel 100 is driven at 120 Hz, in the first period P1, the third period P3, the fifth period P5, and the seventh period P7, the light-emitting element initialization gate signal GB[n] may have the active pulse, and a bias operation may be performed. When the display panel 100 is driven at 60 Hz, in the first period P1, the third period P3, the fifth period P5, and the seventh period P7, the light-emitting element initialization gate signal GB[n] may have the active pulse, and the bias operation may be performed.

As shown in FIG. 4, only the emission signal EM[n], the light-emitting element initialization gate signal GB[n], and the data writing signal GW[n] are shown, but the compensation gate signal GC[n] and the data initialization gate signal GI[n] may also be applied to the pixel like the data writing signal GW[n]. When the display panel 100 is driven at 120 Hz, in the first period P1, the third period P3, the fifth period P5, and the seventh period P7, the compensation gate signal GC[n] and the data initialization gate signal GI[n] may have the active pulse, and when the display panel 100 is driven at 60 Hz, in the first period P1 and the fifth period P5, the compensation gate signal GC[n] and the data initialization gate signal GI[n] may have the active pulse.

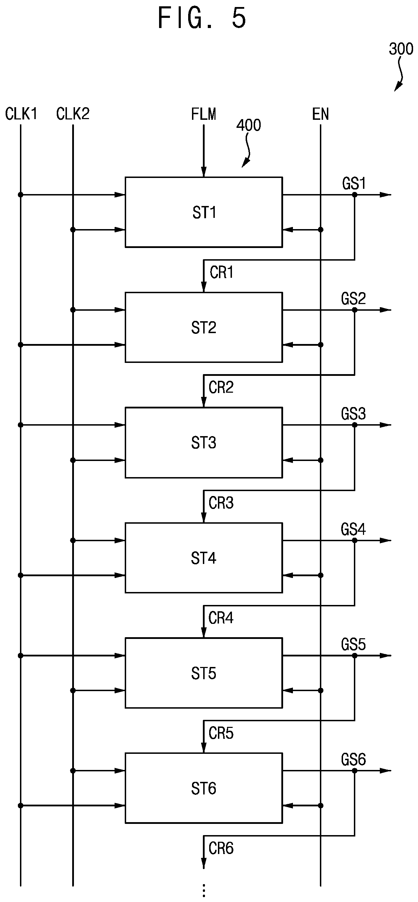

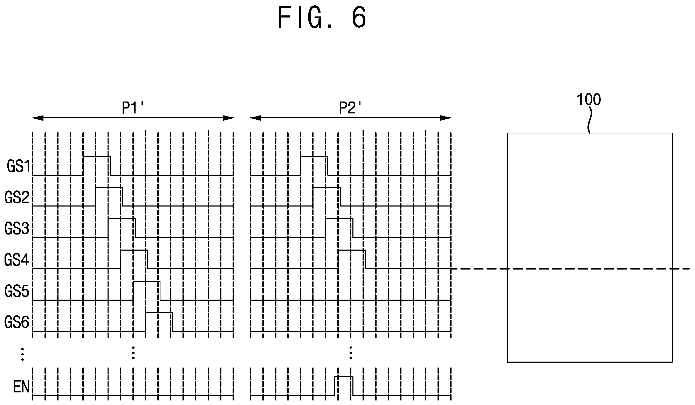

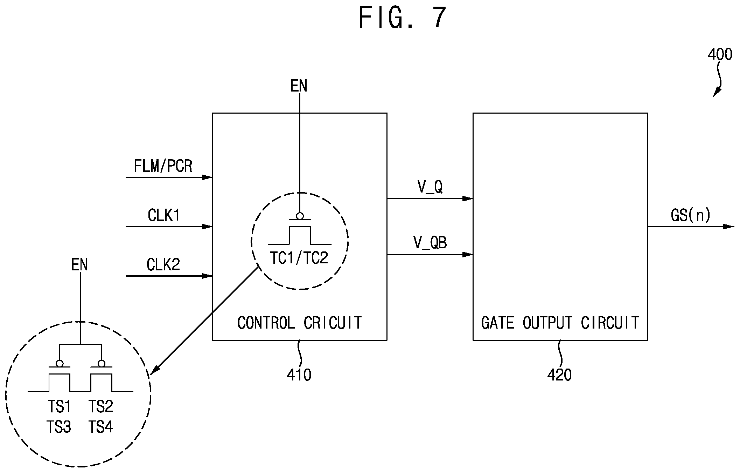

FIG. 5 is a conceptual diagram showing a gate driver 300 of FIG. 1. FIG. 6 is a conceptual diagram showing a driving frequency for each area of a display panel 100 of FIG. 1 in a multi-frequency driving. FIG. 7 is a conceptual diagram showing each stage 400 included in a gate driver 300 of FIG. 6.

Referring to FIGS. 1 to 7, the gate driver 300 may include a plurality of stages ST1, ST2, ST3, ST4, ST5, ST6, ....

The stages ST1, ST2, ST3, ST4, ST5, ST6, ... may receive a gate start signal FLM, a first clock signal CLK1, a second clock signal CLK2, and an enable signal EN. The first clock signal CLK1 and the second clock signal CLK2 may have different phases.

The stages ST1, ST2, ST3, ST4, ST5, ST6, ... may sequentially output gate signals GS1, GS2, GS3, GS4, GS5, GS6, .... Each of the gate signals GS1, GS2, GS3, GS4, GS5, GS6, ... may be provided as carry signals CR1, CR2, CR3, CR4, CR5, CR6, ... to subsequent stages. In an embodiment, odd-numbered stages ST1, ST3, ST5, ... may receive an input signal (e.g., the gate start signal FLM or a previous carry signal CR2, CR4, ...) in response to the first clock signal CLK1 and may initiate output of the gate signals GS1, GS3, GS5, ... in response to the second clock signal CLK2. In an embodiment, even-numbered stages ST2, ST4, ST6, ... may receive the input signal (e.g., a previous carry signal CR1, CR3, CR5, ...) in response to the second clock signal CLK2, and may initiate output of the gate signal GS2, GS4, GS6, ... in response to the first clock signal CLK1. In an embodiment, each of the gate signals GS1, GS2, GS3, GS4, GS5, GS6, ... may be at least one of the data writing gate signal GW[n], the compensation gate signal GC[n], and the data initialization gate signal GI[n],

For example, as shown in FIG. 5, the first stage ST1 may receive the gate start signal FLM in response to the first clock signal CLK1, and output the first gate signal GS1 in response to the second clock signal CLK2. The second stage ST2 may receive the first gate signal GS1 as the first carry signal CR1 in response to the second clock signal CLK2, and output the second gate signal GS2 in response to the first clock signal CLK1. The third stage ST3 may receive the second gate signal GS2 as the second carry signal CR2 in response to the first clock signal CLK1, and output the third gate signal GS3 in response to the second clock signal CLK2. The fourth stage ST4 may receive the third gate signal GS3 as the third carry signal CR3 in response to the second clock signal CLK2, and output the fourth gate signal GS4 in response to the first clock signal CLK1. The fifth stage ST5 may receive the fourth gate signal GS4 as the fourth carry signal CR4 in response to the first clock signal CLK1, and output the fifth gate signal GS5 in response to the second clock signal CLK2. The sixth stage ST6 may receive the fifth gate signal GS5 as the fifth carry signal CR5 in response to the second clock signal CLK2, and output the sixth gate signal GS6 in response to the first clock signal CLK1.

The display panel 100 may perform a Multi-Frequency Driving ("MFD") according to a driving frequency for each area. The stages ST1, ST2, ST3, ST4, ST5, ST6, ... may selectively output the gate signals GS1, GS2, GS3, GS4, GS5, GS6, ... according to a level of the enable signal EN. Specifically, when the enable signal EN has the inactive level before the input signal FLM/PCR has the high level, the gate signal having the low level may be output, and when the enable signal EN has the inactive level after the input signal FLM/PCR has the high level, the gate signal having the high level may be output. Here, the reference character PCR represents a previous carry signal CR1, CR2, CR3, CR4, CR5, CR6,

For example, a switching element receiving the enable signal EN may be the P-type transistor. In this case, the inactive level of the enable signal EN may be the high level, and the active level of the enable signal EN may be the low level. When the enable signal EN has the high level, the switching element receiving the enable signal EN may be turned off.

FIG. 6 exemplifies a case where the switching element receiving the enable signal EN is the P-type transistor, but embodiments of the present invention are not limited thereto.

For example, the switching element receiving the enable signal EN may be the N-type transistor. In this case, the inactive level of the enable signal EN may be the low level, and the active level of the enable signal EN may be the high level. When the enable signal EN has the low level, the switching element receiving the enable signal EN may be turned off.

As shown in FIG. 6, in a first period P1', the enable signal EN may have the low level, and in the first period P1', the gate signals GS1, GS2, GS3, GS4, GS5, GS6, ... having the high level may be sequentially output. In a second period P2', the enable signal EN may have the high level, and in the second period P2', the first to fourth gate signals GS1, GS2, GS3, GS4 having the high level may be output, and subsequent gate signals GS5, GS6, ... having the low level may be output.

FIG. 6 exemplifies a case where the gate signals GS1, GS2, GS3, GS4, GS5, GS6, ... have the high level when the input signal FLM/PCR has the high level and the enable signal EN has the active level, but embodiments of the present invention are not limited thereto.

When the enable signal EN has the inactive level before the input signal FLM/PCR has the low level, the gate signal having the high level may be output, and when the enable signal EN has the inactive level after the input signal FLM/PCR has the low level, the gate signal having the low level may be output.

In an embodiment, the stages ST1, ST2, ST3, ST4, ST5, ST6, ... may further receive a third clock signal (not shown) and a fourth clock signal (not shown). The first clock signal CLK1, the second clock signal CLK2, the third clock signal, and the fourth clock signal may have different phases. In this case, the first stage ST1 may receive the first clock signal CLK1 and the second clock signal CLK2, the second stage ST2 may receive the second clock signal CLK2 and the third clock signal CLK3, the third stage ST3 may receive the third clock signal CLK3 and the fourth clock signal CLK4, the fourth stage ST4 may receive the fourth clock signal CLK4 and the first clock signal CLK1, the fifth stage ST5 may receive the first clock signal CLK1 and the second clock signal CLK2, and the sixth stage ST6 may receive the second clock signal CLK2 and the third clock signal CLK3.

As shown in FIG. 7, each stage 400 may include a control circuit 410 and a gate output circuit 420. The control circuit 410 may control a voltage V_Q of a first node and a voltage V_QB of a second node in response to an input signal FLM/PCR, a first clock signal CLK1, and a second clock signal CLK2. The control circuit 410 may include a first control switching element TC1 selectively connecting the first node and the gate output circuit 420 in response to an enable signal EN. In an embodiment, the control circuit 410 may further include a second control switching element TC2 selectively connecting the second node and the gate output circuit 420 in response to the enable signal EN. In an embodiment, the first control switching element TC1 may include a first sub-switching element TS1 and a second sub-switching element TS2. That is, the first control switching element TC1 may have a dual transistor structure including two transistors. In an embodiment, the second control switching element TC2 may include a third sub-switching element TS3 and a fourth sub-switching element TS4. That is, the second control switching element TC2 may have the dual transistor structure including two transistors.

The gate output circuit 420 may output a gate signal GS(n) in response to the voltage V_Q of the first node and the voltage V_QB of the second node.

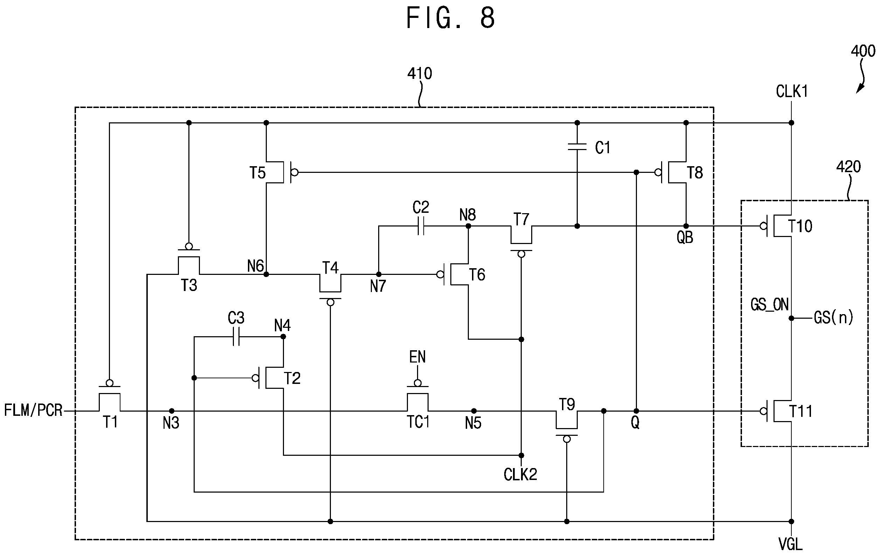

FIG. 8 is a circuit diagram showing an example of each stage 400 of FIG. 7.

Referring to FIG. 8, each stage 400 may include a control circuit 410 and a gate output circuit 420. The control circuit 410 may control a voltage V_Q of a first node Q and a voltage V_QB of a second node QB in response to an input signal FLM/PCR, a first clock signal CLK1, and a second clock signal CLK2. The control circuit 410 may include a first control switching element TC1 selectively connecting the first node Q and the gate output circuit 420 in response to an enable signal EN. In addition, the gate output circuit 420 may output a gate signal GS(n) in response to the voltage V_Q of the first node Q and the voltage V_QB of the second node QB. In an embodiment, the gate signal GS(n) may be one of a compensation gate signal GC[n] and a data initialization gate signal GI[n] applied to a pixel. The control circuit 410 may include a first switching element T1, a second switching element T2, a ninth switching element T9, a first control switching element TC1, and a third capacitor C3. The control circuit 410 may further include a third switching element T3, a fourth switching element T4, a fifth switching element T5, a sixth switching element T6, a seventh switching element T7, an eighth switching element T8, a first capacitor C1, and a second capacitor C2.

The first switching element T1 may include a gate electrode receiving the first clock signal CLK1, a first electrode receiving the input signal FLM/PCR, and a second electrode connected to a third node N3.

The second switching element T2 may include a gate electrode connected to the first node Q, a first electrode receiving the second clock signal CLK2, and a second electrode connected to the fourth node N4.

The third switching element T3 may include a gate electrode receiving the first clock signal CLK1, a first electrode receiving a gate low voltage VGL, and a second electrode connected to the sixth node N6.

The fourth switching element T4 may include a gate electrode receiving the gate low voltage VGL, a first electrode connected to the sixth node N6, and a second electrode connected to the seventh node N7.

The fifth switching element T5 may include a gate electrode connected to the first node Q, a first electrode receiving the first clock signal CLK1, and a second electrode connected to the sixth node N6.

The sixth switching element T6 may include a gate electrode connected to the seventh node N7, a first electrode receiving the second clock signal CLK2, and a second electrode connected to an eighth node N8.

The seventh switching element T7 may include a gate electrode receiving the second clock signal CLK2, a first electrode connected to the eighth node N8, and a second electrode connected to the second node QB.

The eighth switching element T8 may include a gate electrode connected to the first node Q, a first electrode receiving the first clock signal CLK1, and a second electrode connected to the second node QB.

The first control switching element TC1 may include a gate electrode receiving the enable signal EN, a first electrode connected to the third node N3, and a second electrode connected to a fifth node N5. In an embodiment, the first control switching element TC1 may include a first sub-switching element TS1 and a second sub-switching element TS2. That is, the first control switching element TC1 may have a dual transistor structure including two transistors.

The ninth switching element T9 may include a gate electrode receiving the gate low voltage VGL, a first electrode connected to the fifth node N5, and a second electrode connected to the first node Q.

The first capacitor C1 may include a first electrode receiving the first clock signal CLK1 and a second electrode connected to the second node QB.

The second capacitor C2 may include a first electrode connected to the seventh node N7 and a second electrode connected to the eighth node N8.

The third capacitor C3 may include a first electrode connected to the fourth node N4 and a second electrode connected to the first node Q.

The gate output circuit 420 may include a tenth switching element T10 and an eleventh switching element T11.

The tenth switching element T10 may include a gate electrode connected to the second node QB, a first electrode receiving the first clock signal CLK1, and a second electrode connected to a gate output node GS_ON.

The eleventh switching element T11 may include a gate electrode connected to the first node Q, a first electrode receiving the gate low voltage VGL, and a second electrode connected to the gate output node GS_ON.

In this embodiment, each stage 400 including only P-type transistors is exemplified, but embodiments of the present invention are not limited thereto. A leakage current may be generated more in P-type transistors than in N-type transistors. Therefore, some of the switching elements included in each stage 400 may be the N-type transistors in another embodiment. For example, the first control switching element TC1 may be the N-type transistor and the first to eleventh switching elements T1 to T11 may be the P-type transistors.

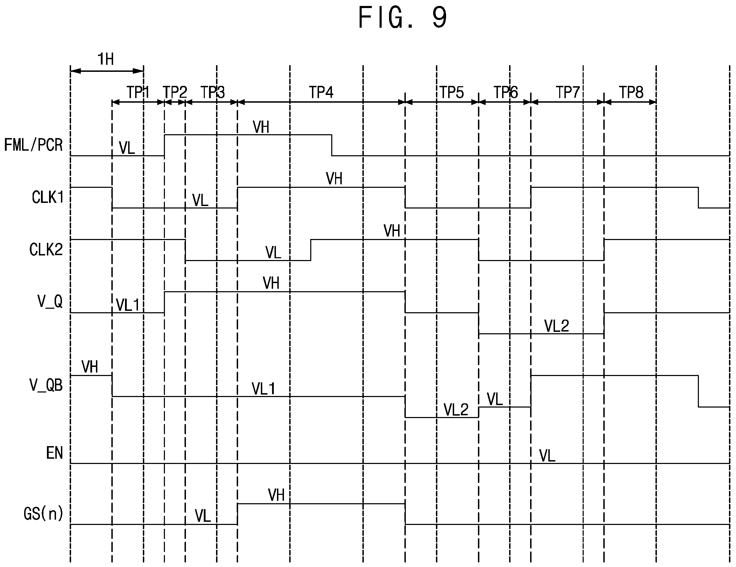

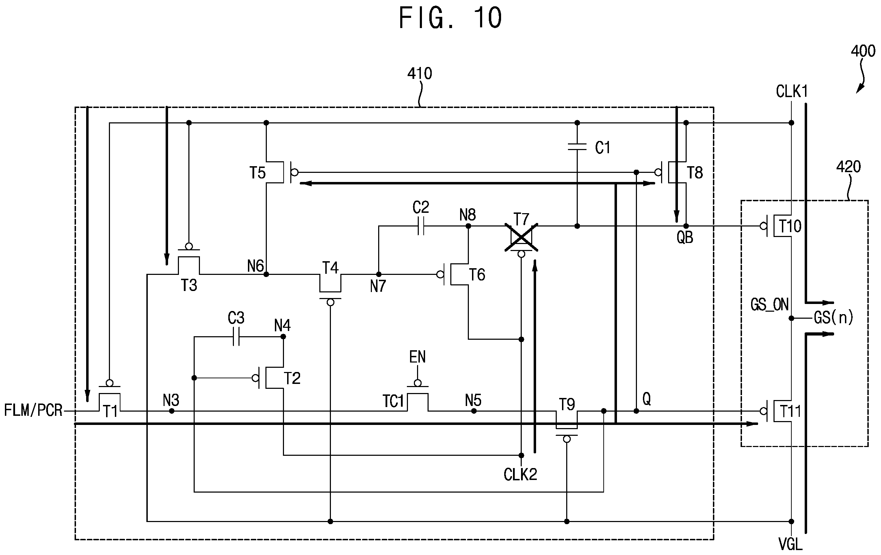

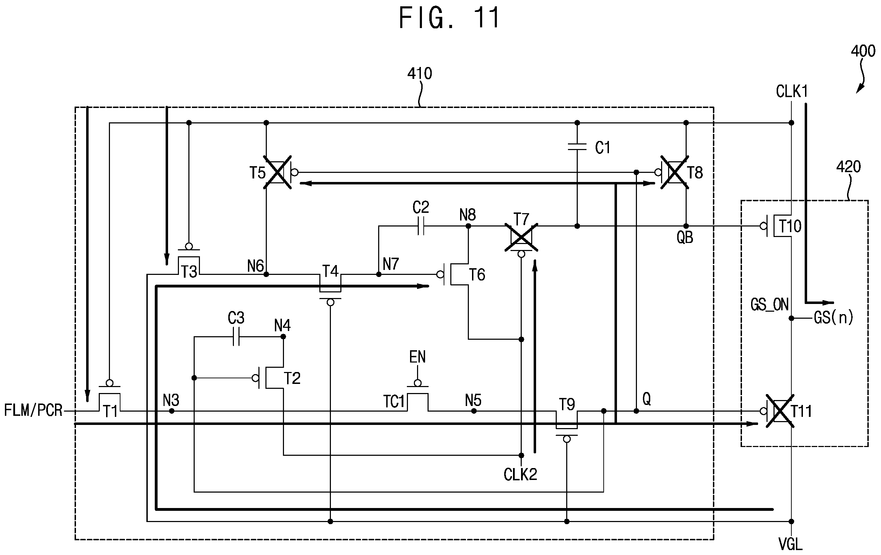

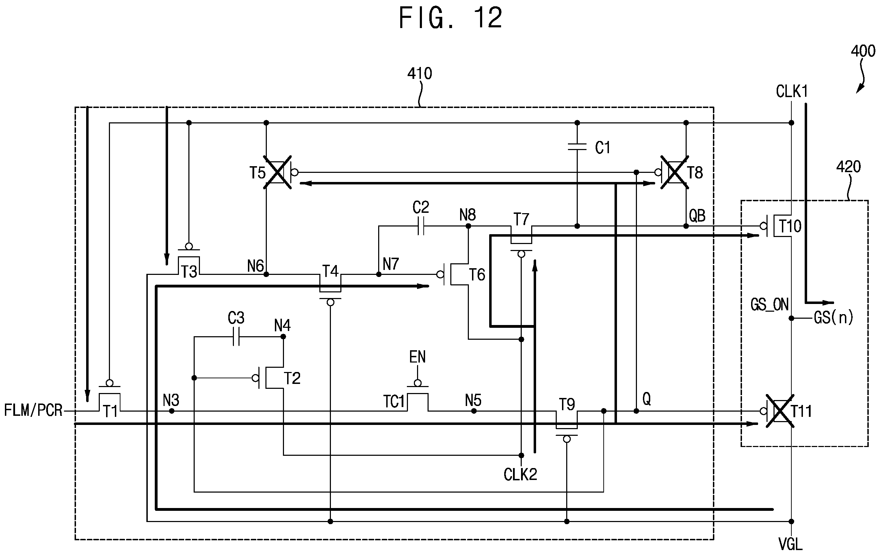

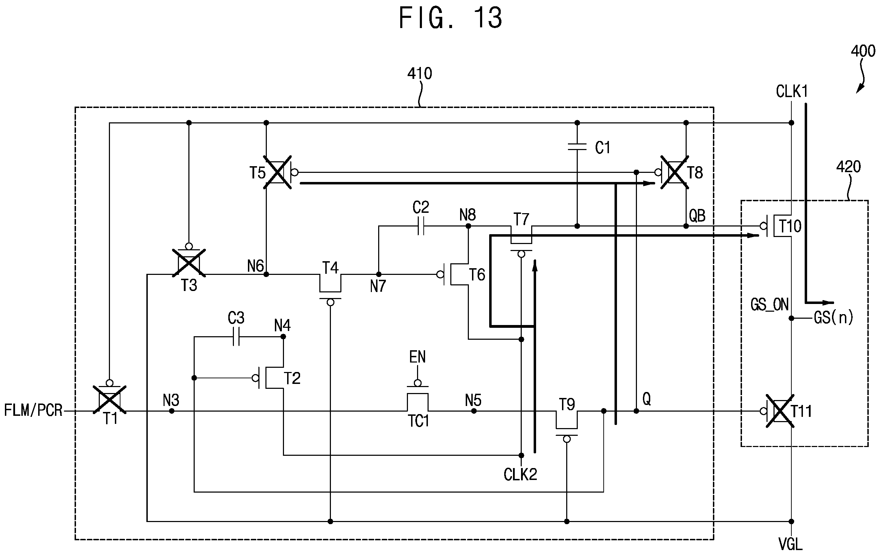

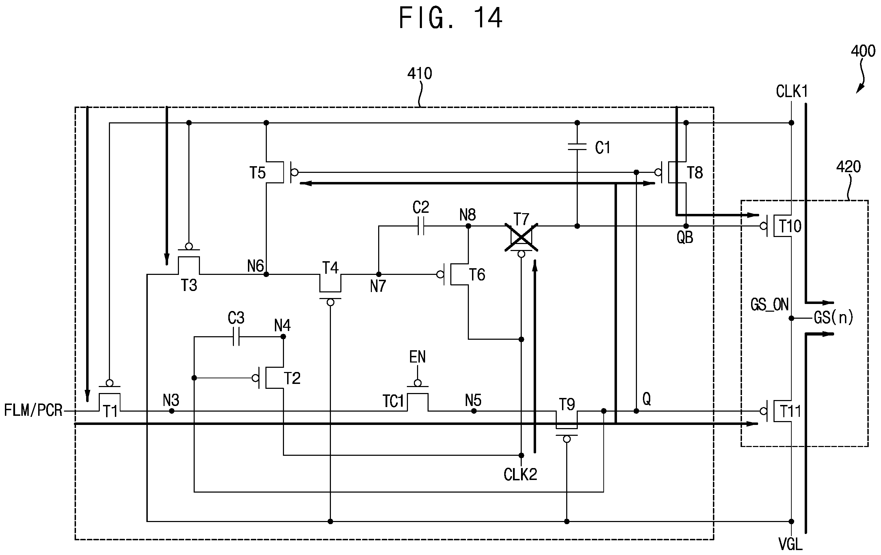

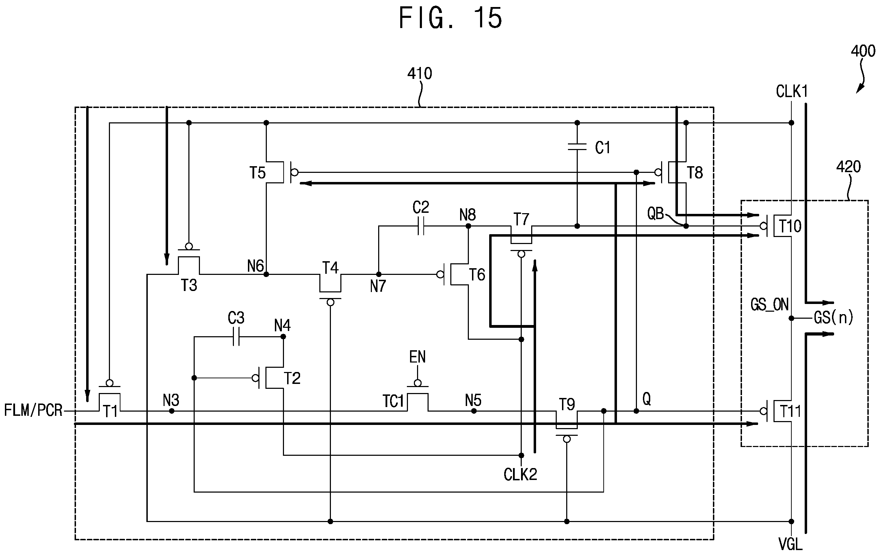

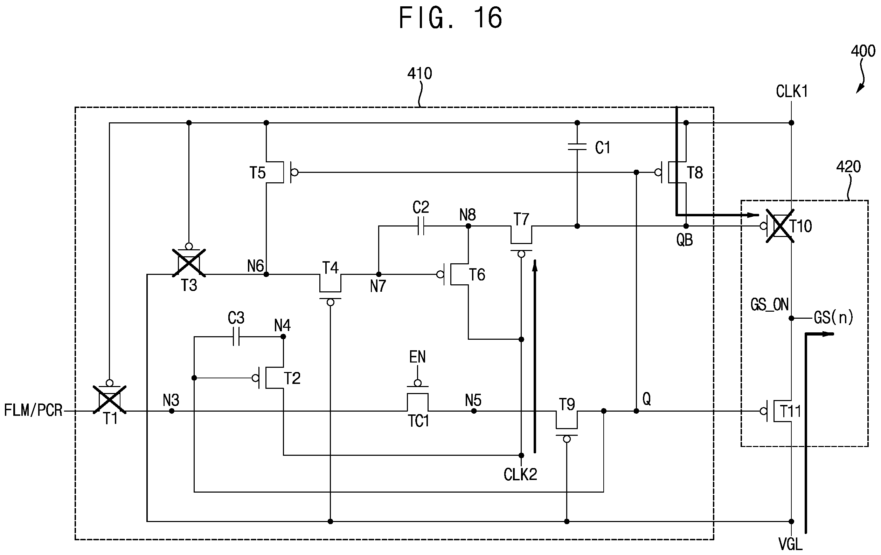

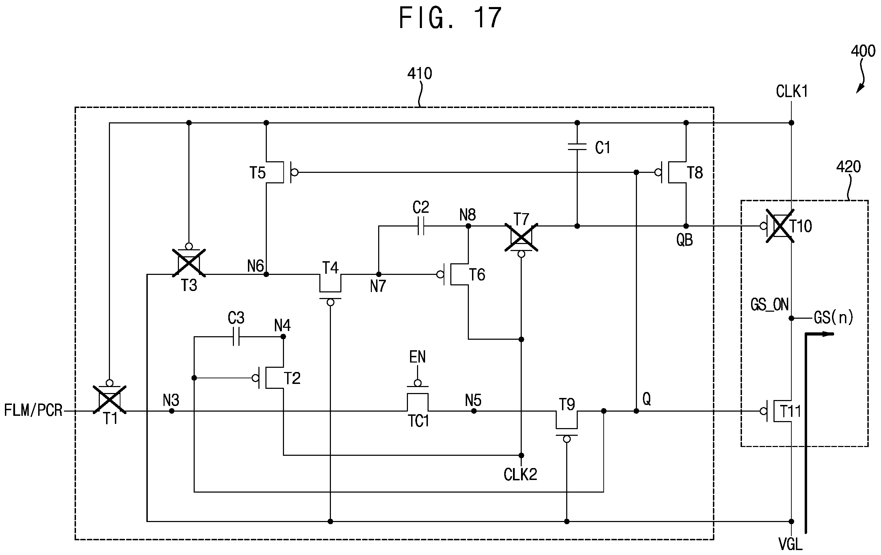

FIG. 9 is a timing diagram showing an input signal FLM/PCR, a first clock signal CLK1, a second clock signal CLK2, node signals V_Q, V_QB, an enable signal EN, and an output signal GS(n) of each stage 400 of FIG. 8 when the enable signal EN has an active level. FIG. 10 is a circuit diagram showing an operation of each stage 400 of FIG. 8 in a first time period TP1 of FIG. 9. FIG. 11 is a circuit diagram showing an operation of each stage 400 of FIG. 8 in a second time period TP2 of FIG. 9. FIG. 12 is a circuit diagram showing an operation of each stage 400 of FIG. 8 in a third time period TP3 of FIG. 9. FIG. 13 is a circuit diagram showing an operation of each stage 400 of FIG. 8 in a fourth time period TP4 of FIG. 9. FIG. 14 is a circuit diagram showing an operation of each stage 400 of FIG. 8 in a fifth time period TP5 of FIG. 9. FIG. 15 is a circuit diagram showing an operation of each stage 400 of FIG. 8 in a sixth time period TP6 of FIG. 9. FIG. 16 is a circuit diagram showing an operation of each stage 400 of FIG. 8 in a seventh time period TP7 of FIG. 9. FIG. 17 is a circuit diagram showing an operation of each stage 400 of FIG. 8 in an eighth time period TP8 of FIG. 9.

Referring to FIGS. 8 to 17, an operation of each stage 400 may be explained when the first control switching element TC1 maintains a turn-on state in response to the enable signal EN having an active level. The active level may be a level which turns on a switching element. For example, an active level of the N-type transistor may be a high level VH, and an active level of the P-type transistor may be a first low level VL1, a low level VL, and a second low level VL2. The first low level VL1 may be higher than the low level VL, and the second low level VL2 may be lower than the low level VL.

An inactive level may be a level which turns off the switching element. For example, an inactive level of the N-type transistor may be the first low level VL1, the low level VL, and the second low level VL2, and an inactive level of the P-type transistor may be the high level VH.

As shown in FIG. 10, in a first time period TP1, the input signal FLM/PCR may have the low level VL, the first clock signal CLK1 may have the low level VL, and the second clock signal CLK2 may have the high level VH.

The first switching element T1 may be turned on in response to the first clock signal CLK1 having the low level VL. The ninth switching element T9 may be turned on in response to a gate low voltage VGL. A level of the gate low voltage VGL may be the low level VL. The first switching element T1 may apply the input signal FLM/PCR having the low level VL to the third node N3 and the first node Q. Due to a characteristics of the P-type transistor, even if the input signal FLM/PCR has the low level VL, the first node Q may have the first low level VL1 which is reduced by a threshold voltage of the first switching element T1, the first control switching element TC1, or the ninth switching element T9 from the low level VL.

The eighth switching element T8 may be turned on in response to the voltage V_Q of the first node Q having the first low level VL1 and may apply the first clock signal CLK1 having the low level VL to the second node QB. However, since the first low level VL1 is higher than the low level VL, the eighth switching element T8 may not be completely turned on. Therefore, the voltage V_QB of the second node QB may have the first low level VL1 higher than the low level VL.

The tenth switching element T10 may be turned on in response to the voltage V_QB of the second node QB having the first low level VL1 and may apply the first clock signal CLK1 having the low level VL to the gate output node GS_ON. The eleventh switching element T11 may be turned on in response to the voltage V_Q of the first node Q having the first low level VL1 and may apply the gate low voltage VGL to the gate output node GS_ON. Therefore, the gate signal GS(n) having the low level VL may be output from the gate output node GS_ON.

As shown in FIG. 11, in a second time period TP2, the input signal FLM/PCR may have the high level VH, the first clock signal CLK1 may have the low level VL, and the second clock signal CLK2 may have the high level VH.

Since the first clock signal CLK1 maintains the low level VL, the first switching element T1 may maintain a turn-on state and apply the input signal FLM/PCR having the high level VH to the third node N3 and the first node Q. Therefore, the voltage V_Q of the first node Q may have the high level VH. Therefore, the second capacitor C2 may be charged by a difference between the voltage of the seventh node N7 having the low level VL and the voltage of the eighth node N8 having the high level VH.

The third switching element T3 may be turned on in response to the first clock signal CLK1 having the low level VL, and the fourth switching element T4 may be turned on in response to the gate low voltage VGL. Therefore, the voltage of the seventh node N7 may have the low level VL, and the sixth switching element T6 may be turned on in response to the voltage of the seventh node N7 having the low level VL. The seventh switching element T7 may be turned off in response to the second clock signal CLK2 having the high level VH, and the voltage of the eighth node N8 may have the high level VH. The seventh switching element T7 may be turned off in response to the second clock signal CLK2 having the high level VH.

The fifth switching element T5 and the eighth switching element T8 may be turned off in response to the voltage V_Q of the first node Q having the high level VH, and the voltage V_QB of the second node QB may maintain the first low level VL1 which is a previous voltage of the voltage V_QB of the second node QB by the first capacitor C1.

The tenth switching element T10 may be turned on in response to the voltage V_QB of the second node QB having the first low level VL1. Therefore, the tenth switching element T10 may apply the first clock signal CLK1 having the low level VL to the gate output node GS_ON. Accordingly, the gate signal GS(n) having the low level may be output from the gate output node GS_ON.

As shown in FIG. 12, in a third time period TP3, the input signal FLM/PCR may have the high level VH, the first clock signal CLK1 may have the low level VL, and the second clock signal CLK2 may have the low level VL.

The seventh switching element T7 may be turned on in response to the second clock signal CLK2 having the low level VL, the third switching element T3 may be turned on in response to the first clock signal CLK1 having the low level VL, and the fourth switching element T4 may be turned on in response to the gate low voltage VGL. Therefore, the voltage of the seventh node N7 may have the low level VL, and the sixth switching element T6 may be turned on in response to the voltage of the seventh node N7 having the low level VL and apply the second clock signal CLK2 having the low level VL to the eighth node N8 and the second node QB. The voltage V_QB of the second node QB may have the first low level VL1, and the tenth switching element T10 may be turned on in response to the voltage V_QB of the second node QB having the first low level VL1. Therefore, the tenth switching element T10 may apply the first clock signal CLK1 having the low level VL to the gate output node GS_ON. Accordingly, the gate signal GS(n) having the low level VL may be output from the gate output node GS_ON.

As shown in FIG. 13, in a fourth time period TP4, the input signal FLM/PCR may maintain the high level VH and then change from the high level VH to the low level VL, the first clock signal CLK1 may have the high level VH, and the second clock signal CLK2 may maintain the low level VL and then change from the low level VL to the high level VH.

The seventh switching element T7 may be turned on in response to the second clock signal CLK2 having the low level VL, and the sixth switching element T6 may be turned on in response to the voltage of the seventh node N7 having the low level VL maintained by the second capacitor C2, and may apply the second clock signal CLK2 having the low level VL to the second node QB. Accordingly, the first capacitor C1 may be charged by a difference between the high level VH of the first clock signal CLK1 and the low level VL of the voltage V_QB of the second node QB.

The voltage V_QB of the second node QB may have the first low level VL1, and the tenth switching element T10 may be turned on in response to the voltage V_QB of the second node QB having the first low level VL1. Therefore, the tenth switching element T10 may apply the first clock signal CLK1 having the high level VH to the gate output node GS_ON. Accordingly, the gate signal GS(n) having the high level VH may be output from the gate output node GS_ON.

As shown in FIG. 14, in a fifth time period TP5, the input signal FLM/PCR may have the low level VL, the first clock signal CLK1 may have the low level VL, and the second clock signal CLK2 may have the high level VH.

The first switching element T1 may be turned on in response to the first clock signal CLK1 having the low level VL. The ninth switching element T9 may be turned on in response to the gate low voltage VGL. The first switching element T1 may apply the input signal FLM/PCR having the low level VL to the third node N3 and the first node Q. The first node Q may have the first low level VL1 as in the first time period TP1.

Since the seventh switching element T7 is turned off in response to the second clock signal CLK2 having the high level VH, the first capacitor C1 may be floated, and as the fourth time period TP4 changes to the fifth time period TP5, the first clock signal CLK1 may change from the high level VH to the low level VL. Therefore, the voltage V_QB of the second node QB may be boosted while maintaining a difference between the high level VH and the low level VL, which are voltages charged to opposite electrodes of the first capacitor C1. That is, the voltage V_QB of the second node QB may be changed from the first low level to the second low level VL2 which is decreased by the difference between the high level VH and the low level VL.

The tenth switching element T10 may be turned on in response to the voltage V_QB of the second node QB having the second low level VL2 and may apply the first clock signal CLK1 having the low level VL to the gate output node GS_ON. The eleventh switching element T11 may be turned on in response to the voltage V_Q of the first node Q having the first low level VL and may apply the gate low voltage VGL to the gate output node GS_ON. Therefore, the gate signal GS(n) having the low level VL may be output from the gate output node GS_ON.

As such, the gate output circuit 420 may output the gate signal GS(n) having the high level VH in the fourth time period TP4.

As shown in FIG. 15, in a sixth time period TP6, the input signal FLM/PCR may have the low level VL, the first clock signal CLK1 may have the low level VL, and the second clock signal CLK2 may have the low level VL.

Since the first clock signal CLK1 maintains the low level VL, the first switching element T1 may maintain a turn-on state and apply the input signal FLM/PCR having the low level VL to the third node N3 and the first node Q.

As the fifth time period TP5 changes to the sixth time period TP6, the second clock signal CLK2 may change from the high level VH to the low level VL. Therefore, the voltage V_Q of the first node Q may be boosted while maintaining the voltage charged on opposite electrodes of the third capacitor C3. That is, the voltage V_Q of the first node Q may be changed from the first low level VL1 to the second low level VL2 which is decreased by the difference between the high level VH and the low level VL.

In the first time period TP1, the second switching element T2 may be turned on in response to the voltage V_Q of the first node Q having the first low level VL1, and the second clock signal CLK2 having the high level VH may be applied to the fourth node N4. Accordingly, the third capacitor C3 may be charged by the difference between the voltage V_Q of the first node Q having the low level VL and the second clock signal CLK2 having the high level VH. As the fifth time period TP5 changes to the sixth time period TP6, the second clock signal CLK2 may change from the high level VH to the low level VL. Therefore, the voltage V_Q of the first node Q may be boosted while maintaining the difference between the high level VH and the low level VL, which are the voltages charged to opposite electrodes of the third capacitor C3. That is, the voltage V_Q of the first node Q may be changed from the first low level VL1 to the second low level VL2 which is decreased by the difference between the high level VH and the low level VL.

Since the second low level VGL2 is lower than the low level VL, the eighth switching element T8 may be completely turned on and may apply the first clock signal CLK1 having the low level VL to the second node QB. Therefore, the voltage V_QB of the second node QB may have the low level VL.

The tenth switching element T10 may be turned on in response to the voltage V_QB of the second node QB having the low level VL and may apply the first clock signal CLK1 having the low level VL to the gate output node GS_ON. The eleventh switching element T11 may be turned on in response to the voltage V_Q of the first node Q having the second low level VL2 and may apply the gate low voltage VGL to the gate output node GS_ON. Therefore, the gate signal GS(n) having the low level VL may be output from the gate output node GS_ON.

As shown in FIG. 16, in a seventh time period TP7, the input signal FLM/PCR may have the low level VL, the first clock signal CLK1 may have the high level VH, and the second clock signal CLK2 may have the low level VL.

The voltage V_Q of the first node Q may maintain the second low level VL2. In response to the voltage V_Q of the first node Q having the second low level VL2, the eighth switching element T8 may be turned on, and the eighth switching element T8 may apply the first clock signal CLK1 having the high level VH to the second node QB. The fifth switching element T5 may be turned on in response to the voltage V_Q of the first node Q having the second low level VL2, and the fifth switching element T5 and the fourth switching element T4 may apply the first clock signal CLK1 having the high level VH to the seventh node N7. The sixth switching element T6 may be turned off in response to the voltage of the seventh node N7 having the high level VH, and the voltage of the eighth node N8 may have the high level VH by the second capacitor C2. The seventh switching element T7 may be turned on in response to the second clock signal CLK2 having the low level VL and may apply the voltage of the eighth node N8 having the high level VH to the second node QB.

The eleventh switching element T11 may be turned on in response to the voltage V_Q of the first node Q having the second low level VL2 and may apply the gate low voltage VGL to the gate output node GS_ON. Therefore, the gate signal GS(n) having the low level VL may be output from the gate output node GS_ON.

As shown in FIG. 17, in an eighth time period TP8, the input signal FLM/PCR may have the low level VL, the first clock signal CLK1 may have the high level VH, and the second clock signal CLK2 may have the high level VH.

The voltage V_Q of the first node Q may have the first low level VL1, and the voltage V_QB of the second node QB may have the high level VH.

The eleventh switching element T11 may be turned on in response to the voltage V_Q of the first node Q having the first low level VL1 and may apply the gate low voltage VGL to the gate output node GS_ON. Therefore, the gate signal GS(n) having the low level VL may be output from the gate output node GS_ON.

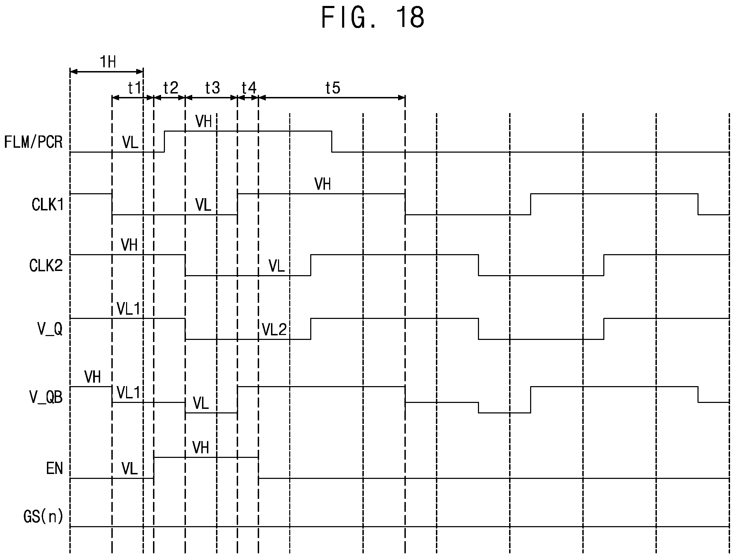

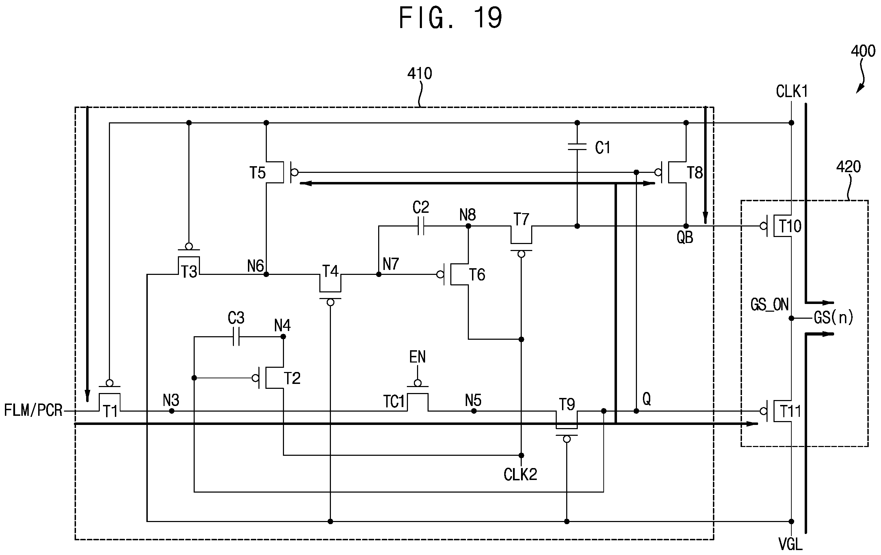

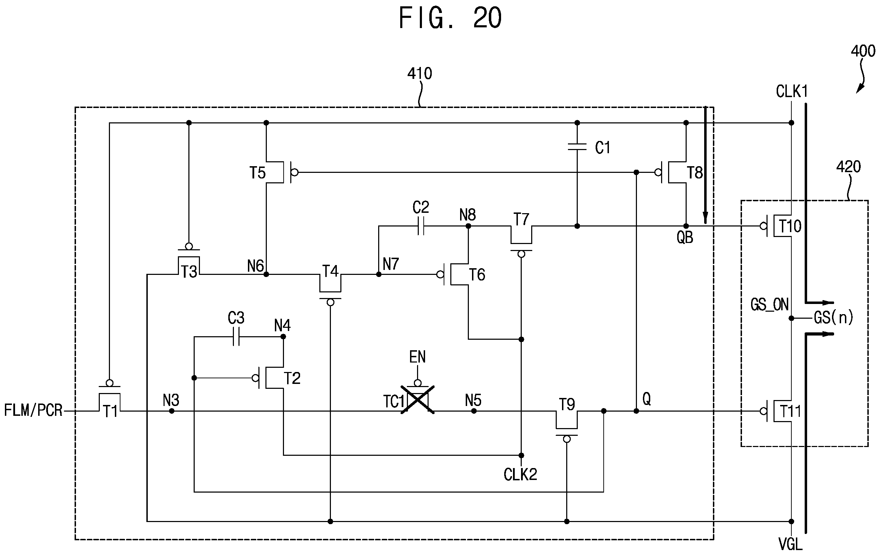

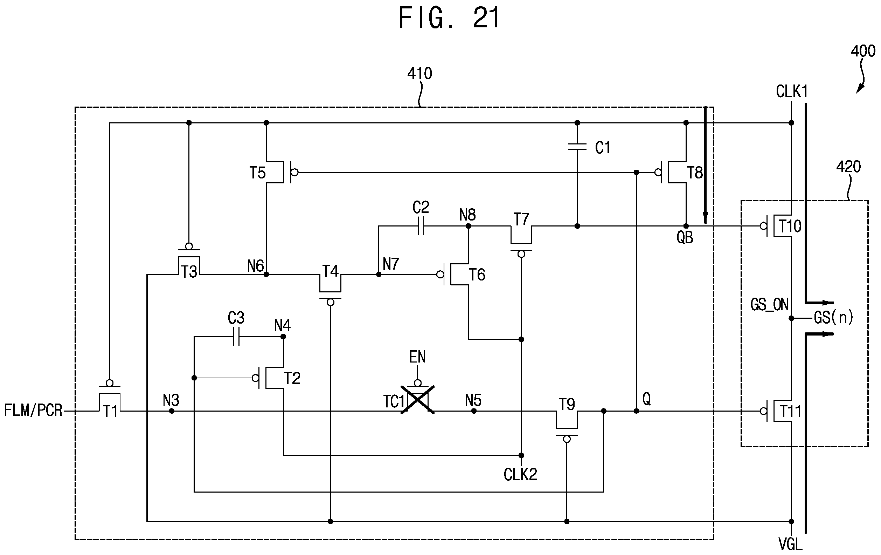

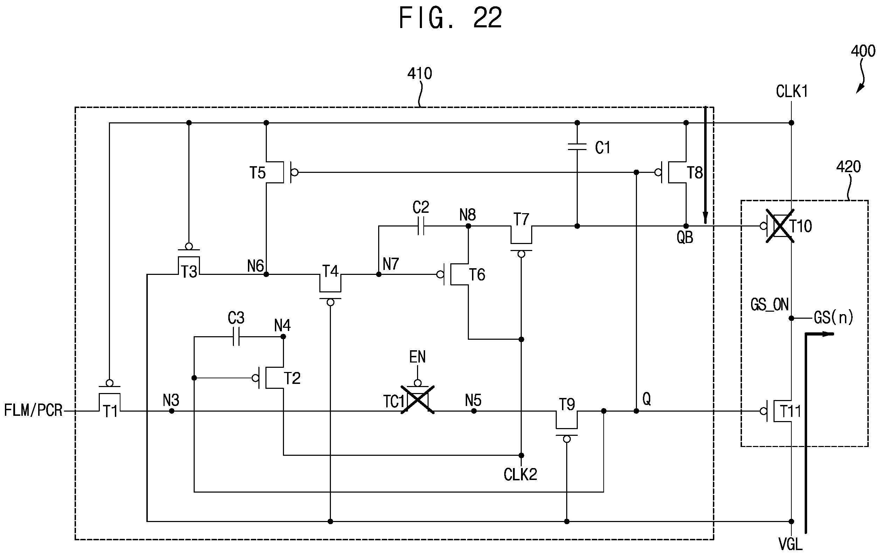

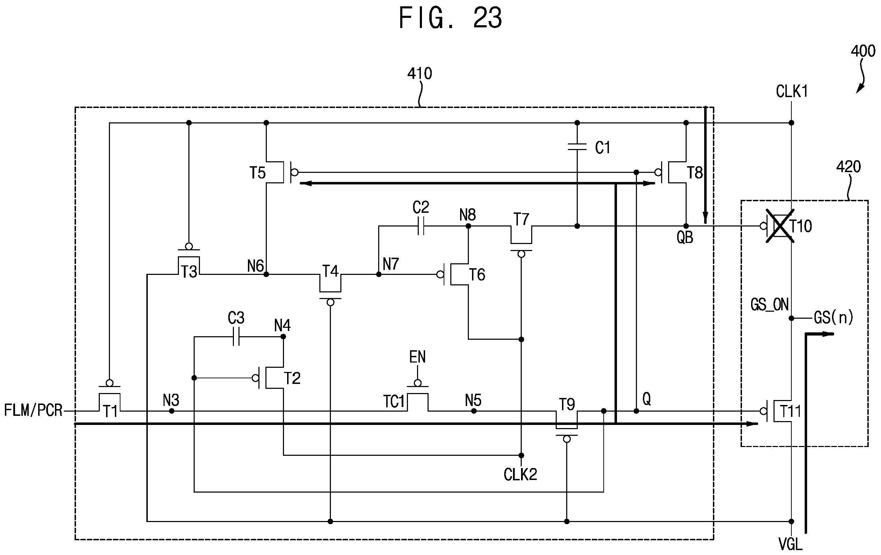

FIG. 18 is a timing diagram showing an input signal FLM/PCR, a first clock signal CLK1, a second clock signal CLK2, node signals V_Q, V_QB, and an output signal GS(n) of each stage 400 of FIG. 8 when an enable signal EN has an inactive level. FIG. 19 is a circuit diagram showing an operation of each stage 400 of FIG. 8 in a first time period t1 of FIG. 18. FIG. 20 is a circuit diagram showing an operation of each stage 400 of FIG. 8 in a second time period t2 of FIG. 18. FIG. 21 is a circuit diagram showing an operation of each stage 400 of FIG. 8 in a third time period t3 of FIG. 18. FIG. 22 is a circuit diagram showing an operation of each stage 400 of FIG. 8 in a fourth time period t4 of FIG. 18. FIG. 23 is a circuit diagram showing an operation of each stage 400 of FIG. 8 in a fifth time period t5 of FIG. 18.

Referring to FIG. 8 and FIGS. 18 to 23, an operation of each stage 400 may be explained when the first control switching element TC1 is turned off in response to the enable signal EN having the inactive level.

The control circuit 410 may include the first control switching element TC1 selectively controlling the voltage V_Q of the first node Q in response to the enable signal EN. The gate output circuit 420 may selectively output the gate signal GS(n) according to the enable signal EN.

When the enable signal EN has the active level, the first control switching element TC1 may transfer the voltage of the third node N3 to the fifth node N5 and the first node Q, and the voltage V_Q of the first node Q may be changed according to the input signal FLM/PCR.

On the other hand, when the enable signal EN has the inactive level, the first control switching element TC1 may not transfer the voltage of the third node N3 to the fifth node N5 and the first node Q, and the voltage V_Q of the first node Q may be maintained lower than a certain level.

As shown in FIG. 19, in a first time period t1, the input signal FLM.PCR may have the low level VL, the first clock signal CLK1 may have the low level VL, the second clock signal CLK2 may have the high level VH, and the enable signal EN may have the low level VL.

The first switching element T1 may be turned on in response to the first clock signal CLK1 having the low level VL. The first control switching element TC1 may be turned on in response to the enable signal EN having the low level VL. The ninth switching element T9 may be turned on in response to the gate low voltage VGL. The first switching element T1 may apply the input signal FLM/PCR having the low level VL to the third node N3 and the first node Q. Due to the characteristics of the P-type transistor, even if the input signal FLM/PCR has the low level VL, the first node Q may have the first low level VL1 that is reduced by the threshold voltage of the first switching element T1, the first control switching element TC1, or the ninth switching element T9 from the low level VL.

The eighth switching element T8 may be turned on in response to the voltage V_Q of the first node Q having the first low level VL1 and may apply the first clock signal CLK1 having the low level VL to the second node QB. However, since the first low level VL1 is higher than the low level VL, the eighth switching element T8 may not be completely turned on. Therefore, the voltage V_QB of the second node QB may have the first low level VL1 higher than the low level VL.

The tenth switching element T10 may be turned on in response to the voltage V_QB of the second node QB which is the first low level VL1 and may apply the first clock signal CLK1 having the low level VL to the gate output node GS_ON. The eleventh switching element T11 may be turned on in response to the voltage V_Q of the first node Q having the first low level VL1 and may apply the gate low voltage VGL to the gate output node GS_ON. Therefore, the gate signal GS(n) having the low level VL may be output from the gate output node GS_ON.

As shown in FIG. 20, in a second time period t2, the input signal FLM/PCR may maintain the low level VL and then change from the low level VL to the high level VH, the first clock signal CLK1 may have the low level VL, the second clock signal CLK2 may have the high level VH, and the enable signal EN may have the high level VH.

The first control switching element TC1 may be turned off in response to the enable signal EN having the high level VH. Therefore, the first control switching element TC1 may not transfer the voltage of the third node N3 to the fifth node N5 and the first node Q.

The voltage V_Q of the first node Q may maintain the first low voltage VL1 which is a previous voltage of the voltage V_Q of the first node Q by the third capacitor C3.

The voltage V_QB of the second node QB may have the first low level VL1 as in the first time period t1.

The tenth switching element T10 may be turned on in response to the voltage V_QB of the second node QB having the first low level VL1 and may apply the first clock signal CLK1 having the low level VL to the gate output node GS_ON. The eleventh switching element T11 may be turned on in response to the voltage V_Q of the first node Q having the first low level VL1 and may apply the gate low voltage VGL to the gate output node GS_ON. Therefore, the gate signal GS(n) having the low level VL may be output from the gate output node GS_ON.

As shown in FIG. 21, in a third time period t3, the input signal FLM/PCR may have the high level VH, the first clock signal CLK1 may have the low level VL, the second clock signal CLK2 may have the low level, and the enable signal EN may have the high level VH.

The first control switching element TC1 may be turned off in response to the enable signal EN having the high level VH. Therefore, the first control switching element TC1 may not transfer the voltage of the third node N3 to the fifth node N5 and the first node Q.

When the second time period t2 changes to the third time period t3, the second clock signal CLK2 may change from the high level VH to the low level VL. Therefore, the voltage V_Q of the first node Q may be boosted by the difference between the high level VH and the low level VL by the third capacitor C3. That is, the voltage V_Q of the first node Q may be boosted from the first low level VL1 to the second low level VL2 by the third capacitor C3.

Since the second low level VGL2 is lower than the low level VL, the eighth switching element T8 may be completely turned on and may apply the first clock signal CLK1 having the low level VL to the second node QB. Therefore, the voltage V_QB of the second node QB may have the low level VL.

The tenth switching element T10 may be turned on in response to the voltage V_QB of the second node QB having the low level VL and may apply the first clock signal CLK1 having the low level VL to the gate output node GS_ON. The eleventh switching element T11 may be turned on in response to the voltage V_Q of the first node Q having the second low level VL2 and may apply the gate low voltage VGL to the gate output node GS_ON. Therefore, the gate signal GS(n) having the low level VL may be output at the gate output node GS_ON.

As shown in FIG. 22, in a fourth time period t4, the input signal FLM/PCR may have the high level VH, the first clock signal CLK1 may have the high level VH, the second clock signal CLK2 may have the low level VL, and the enable signal EN may have the high level VH.

The first control switching element TC1 may be turned off in response to the enable signal EN having the high level VH. Therefore, the first control switching element TC1 may not transfer the voltage of the third node N3 to the fifth node N5 and the first node Q.

The voltage V_Q of the first node Q may maintain the first low voltage VL1, which is the previous voltage of the voltage V_Q of the first node Q, by the third capacitor C3. The eighth switching element T8 may be turned on in response to the voltage V_Q of the first node Q having the first low level VL1, and the eighth switching element T8 may apply the first clock signal CLK1 having the high level VH to the second node QB.

The eleventh switching element T11 may be turned on in response to the voltage V_Q of the first node Q having the first low level VL1 and may apply the gate low voltage VGL to the gate output node GS_ON. Therefore, the gate signal GS(n) having the low level VL may be output from the gate output node GS_ON.

As shown in FIG. 23, in a fifth time period t5, the input signal FLM/PCR may maintain the high level VH and then change from the high level VH to the low level VL, the first clock signal CLK1 may have the high level VH, the second clock signal CLK2 may maintain the low level VL and then change from the low level VL to the high level VH, and the enable signal EN may have the low level VL. Since the first switching element T1 may be turned off in response to the first clock signal CLK1 having the high level VH, the voltage V_Q of the first node Q may maintain a previous voltage of the voltage V_Q of the first node Q by the third capacitor C3. When the second clock signal CLK2 changes from the low level VL to the high level VH, the voltage V_Q of the first node Q may be boosted by the third capacitor C3. That is, the voltage V_Q of the first node Q may be changed from the second low level VL2 to the first low level VL1.

The eighth switching element T8 may be turned on in response to the voltage V_Q of the first node Q having the first low level VL1, and the eighth switching element T8 may apply the first clock signal CLK1 having the high level VH to the second node QB.

The eleventh switching element T11 may be turned on in response to the voltage V_Q of the first node Q having the second low level VL2 or the first low level VL1 and may apply the gate low voltage VGL to the gate output node GS_ON. Therefore, the gate signal GS(n) having the low level VL may be output from the gate output node GS_ON.

As such, a gate driver 300 and a display device may include a control circuit 410 and a gate output circuit 420, and the control circuit 410 may include a first control switching element TC1 selectively connecting a first node Q and the gate output circuit 420 in response to an enable signal EN, such that a driving frequency multi-division may be supported. Through the driving frequency multi-division, a power consumption of the display device may be effectively reduced.

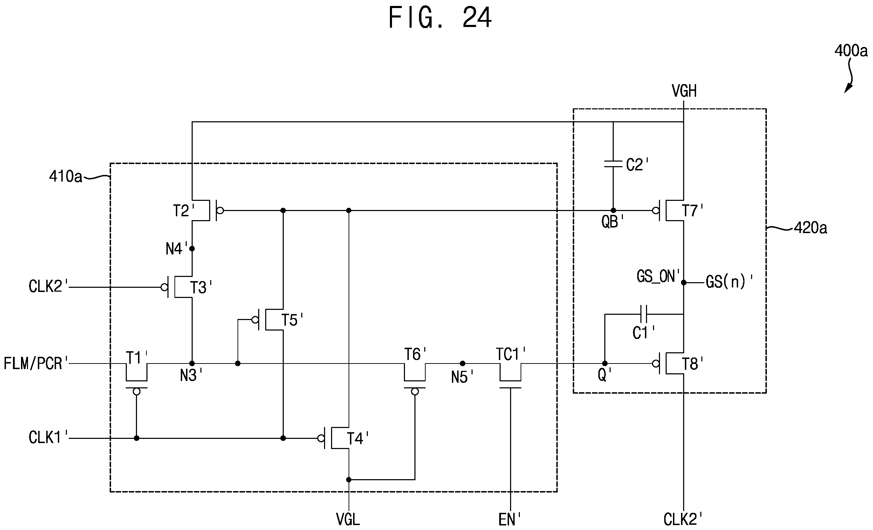

FIG. 24 is a circuit diagram showing another example of each stage 400a of FIG. 7.

Referring to FIG. 24, each stage 400a may include a control circuit 410a and a gate output circuit 420a. The control circuit 410a may control a voltage V_Q' of a first node Q' and a voltage V_QB' of a second node QB' in response to an input signal FLM/PCR', a first clock signal CLK1', and a second clock signal CLK2'. The control circuit 410a may include a first control switching element TC1' selectively connecting the first node Q' and the gate output circuit 420a in response to an enable signal EN'. The gate output circuit 420a may output a gate signal GS(n)' in response to the voltage V_Q' of the first node Q' and the voltage V_QB' of the second node QB'. In an embodiment, the gate signal GS(n)' may be a data writing gate signal GW[n] applied to a pixel.

The control circuit 410a may include a first switching element T1'. The control circuit 410a may further include a first control switching element TC1'. The control circuit 410a may further include a sixth switching element T6'. The control circuit 410a may further include a second switching element T2', a third switching element T3', a fourth switching element T4', and a fifth switching element T5'.

The first switching element T1' may include a gate electrode receiving the first clock signal CLK1', a first electrode receiving the input signal FLM/PCR', and a second electrode connected to a third node N3'.

The second switching element T2' may include a gate electrode connected to the second node QB', a first electrode receiving a gate high voltage VGH, and a second electrode connected to a fourth node N4'.

The third switching element T3' may include a gate electrode receiving the second clock signal CLK2', a first electrode connected to the fourth node N4', and a second electrode connected to the third node N3'.

The fourth switching element T4' may include a gate electrode receiving the first clock signal CLK1', a first electrode receiving a gate low voltage VGL, and a second electrode connected to the second node QB'.

The first control switching element TC1' may include a gate electrode receiving the enable signal EN', a first electrode connected to a fifth node N5', and a second electrode connected to the first node Q'. In an embodiment, the first control switching element TC1' may include a first sub-switching element TS1' and a second sub-switching element TS2'. That is, the first control switching element TC1' may have a dual transistor structure including two transistors.

The fifth switching element T5' may include a gate electrode connected to the third node N3', a first electrode receiving the first clock signal CLK1', and a second electrode connected to the second node QB'.

The sixth switching element T6' may include a gate electrode receiving the gate low voltage VGL, a first electrode connected to the third node N3', and a second electrode connected to the fifth node N5'.

The gate output circuit 420a may include a seventh switching element T7' and an eighth switching element T8'. The gate output circuit 420a may further include a first capacitor C1' and a second capacitor C2'.

The seventh switching element T7' may include a gate electrode connected to the second node QB', a first electrode receiving the gate high voltage VGH, and a second electrode connected to the gate output node GS_ON'.

The eighth switching element T8' may include a gate electrode connected to the first node Q', a first electrode receiving the second clock signal CLK2', and a second electrode connected to the gate output node GS_ON'.

The first capacitor C1' may include a first electrode connected to the first node Q' and a second electrode connected to the gate output node GS _ON'. The first capacitor C1' may store a voltage difference between a voltage of the gate output node GS_ON' and the voltage V_Q' of the first node Q'.

The second capacitor C2' may include a first electrode receiving the gate high voltage VGH and a second electrode connected to the second node QB'. The second capacitor C2' may store a voltage difference between the gate high voltage VGH and the voltage V_QB' of the second node QB'.

A leakage current may be generated more in a P-type transistor than in an N-type transistor. Therefore, some of switching elements included in each stage 400a may be the N-type transistor. For example, the first control switching element TC1' may be the N-type transistor, and the first to eighth switching elements T1' to T8' may be the P-type transistors.

In this embodiment, some of the switching elements of each stage 400a are N-type transistors, and other of the switching elements are P-type transistors. However, embodiments of the present invention are not limited thereto. The present invention may also be applied to each stage including only P-type transistors in another embodiment.

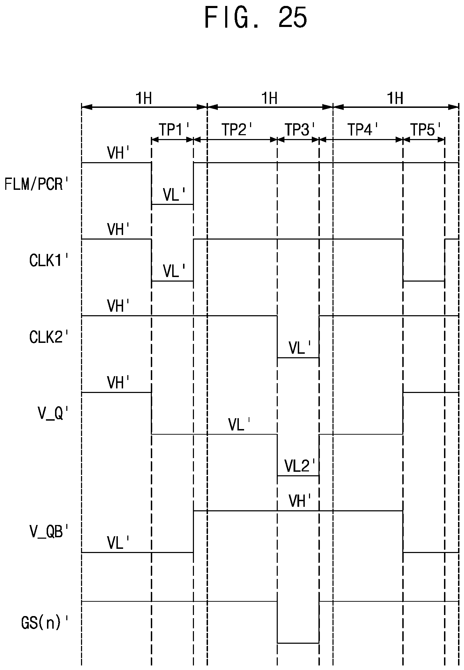

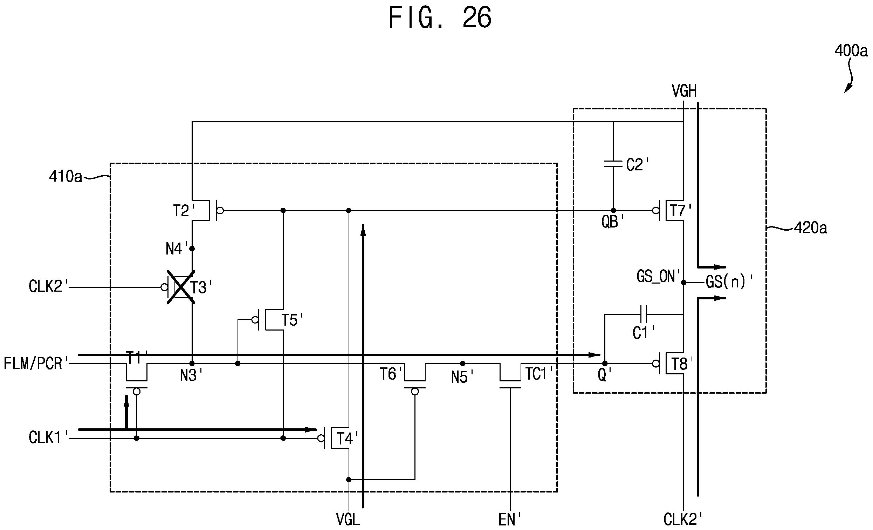

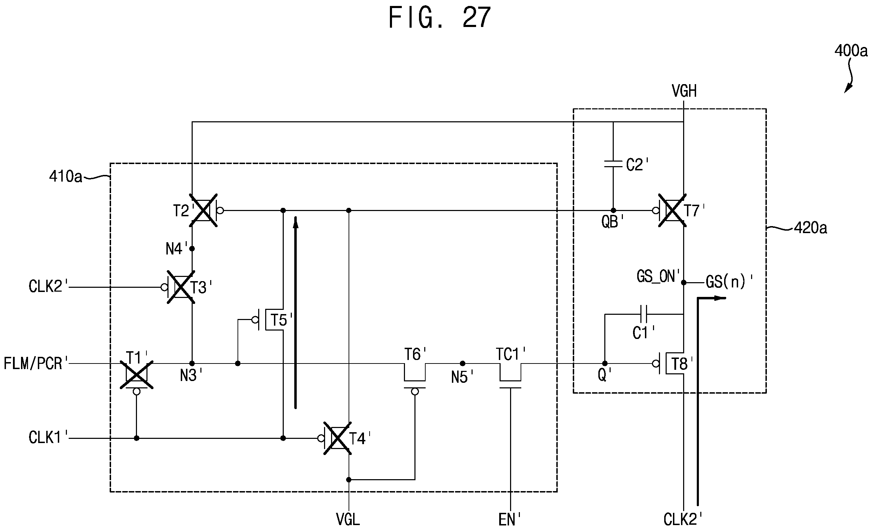

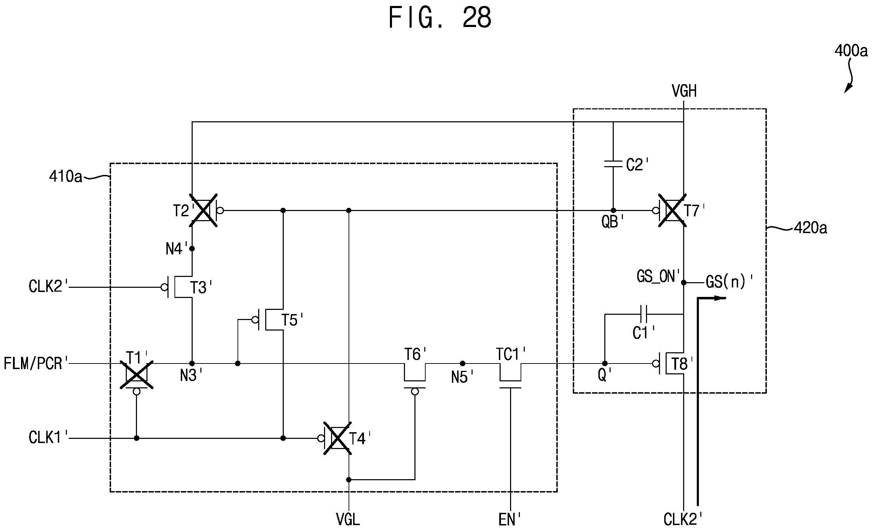

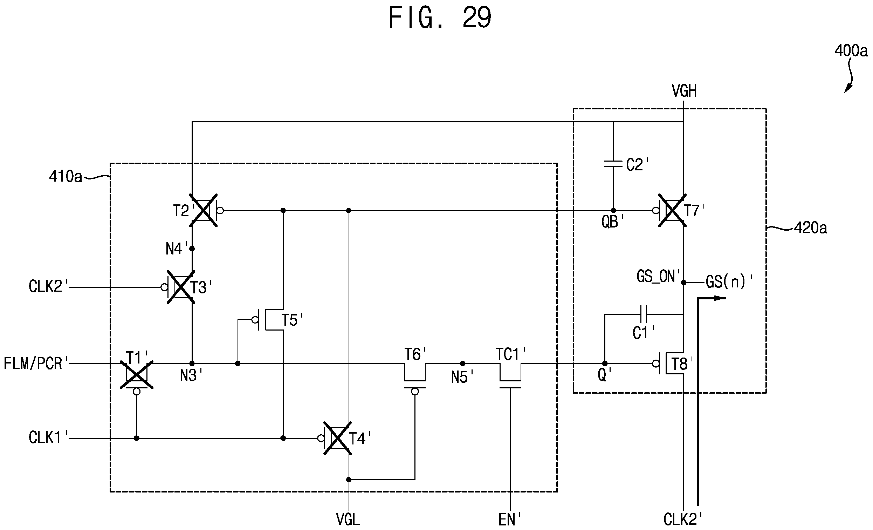

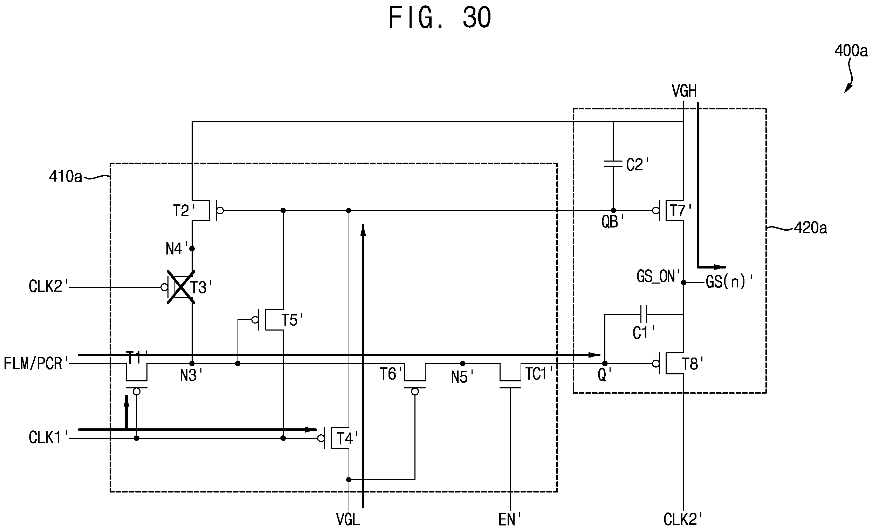

FIG. 25 is a timing diagram showing an input signal FLM/PCR', a first clock signal CLK1', a second clock signal CLK2', node signals V_Q', V_QB', and an output signal GS(n)' of each stage 400a of FIG. 24. FIG. 26 is a circuit diagram showing an operation of each stage 400a of FIG. 24 in a first time period TP1' of FIG. 25. FIG. 27 is a circuit diagram showing an operation of each stage 400a of FIG. 24 in a second time period TP2' of FIG. 25. FIG. 28 is a circuit diagram showing an operation of each stage 400a of FIG. 24 in a third time period TP3' of FIG. 25. FIG. 29 is a circuit diagram showing an operation of each stage 400a of FIG. 24 in a fourth time period TP4' of FIG. 25. FIG. 30 is a circuit diagram showing an operation of each stage 400a of FIG. 24 in a fifth time period TP5' of FIG. 25.

Referring to FIGS. 24 to 30, an operation of each stage 400b is explained when the first control switching element TC1' maintains a turn-on state in response to the enable signal EN' having an active level.

As shown in FIG. 26, in a first time period TP1', the input signal FLM/PCR' may have a low level VL', the first clock signal CLK1' may have the low level VL', and the second clock signal CLK2' may have the high level VH'.

The first switching element T1' may be turned on in response to the first clock signal CLK1' having the low level VL'. The sixth switching element T6' may be turned on in response to the gate low voltage VGL. The first switching element T1' may apply the input signal FLM/PCR' to the third node N3' and the first node Q'. Therefore, the first node Q' may have the low level VL' corresponding to the input signal FLM/PCR', and the first capacitor C1' may be charged.

The fourth switching element T4' may be turned on in response to the first clock signal CLK1' having the low level VL'. The fourth switching element T4' may apply the gate low voltage VGL to the second node QB'. Therefore, the second node QB' may have the low level VL' corresponding to the gate low voltage VGL, and the second capacitor C2' may be charged.

The eighth switching element T8' may be turned on in response to the voltage V_Q' of the first node Q' having the low level VL' and may apply the second clock signal CLK' having the high level VH' to the gate output node GS_ON'. Therefore, the gate signal GS(n)' having the high level VH' may be output from the gate output node GS_ON'.

The seventh switching element T7' may be turned on in response to the voltage V_QB' of the second node QB' which is the low level VL' and may apply the gate high voltage VGH to the gate output node GS _ON'. Therefore, the gate signal GS having the high level VH' may be output from the gate output node GS_ON'.

As shown in FIG. 27, in a second time period TP2', the input signal FLM/PCR' may have the high level VH', the first clock signal CLK1' may have the high level VH', and the second clock signal CLK2' may have the high level VH'. The voltage of the third node N3' may be equal to the voltage V_Q' of the first node Q' having the low level VL'.

The fifth switching element T5' may be turned on in response to the voltage of the third node N3' having the low level VL' and may apply the first clock signal CLK1' having the high level VH' to the second node QB'. Therefore, the second node QB' may have the high level VH' in response to the first clock signal CLK1' having the high level VH', and the second capacitor C2' may be discharged.

As shown in FIG. 28, in a third time period TP3', the input signal FLM/PCR' may have the high level VH', the first clock signal CLK1' may have the high level VH', and the second clock signal CLK2' may have the low level VL'.

The first switching element T1' may be turned off in response to the first clock signal CLK' having the high level VH'. When the second time period TP2' changes to the third time period TP', the voltage V_Q' of the first node Q' may be changed from the low level VL' to the second low level VL2' by the first capacitor C1'. The second low level VL2' may be lower than the low level VL'. Since the fifth switching element T5' continuously applies the first clock signal CLK1' having the high level VH' to the second node QB', the voltage V_QB' of the second node QB' may maintain the high level VH'. Therefore, the eighth switching element T8' may maintain a turn-on state in response to the voltage V_Q' of the first node Q' having the second low level VL2' and may apply the second clock signal CLK2' having the low level VL' to the gate output node GS_ON'. Accordingly, the gate signal GS(n)' having the low level VL' may be output from the gate output node GS_ON'.

As shown in FIG. 29, in a fourth time period TP4', the input signal FLM/PCR' may have the high level VH', the first clock signal CLK1' may have the high level VH', the second clock signal CLK2' may have the low level VL', and the voltage V_Q' of the first node Q' may have the low level VL2. The eighth switching element T8' may maintain a turn-on state in response to the voltage V_Q' of the first node Q' having the low level VL' and may apply the second clock signal CLK2' having the high level VH' to the gate output node GS_ON'. Therefore, the gate signal GS(n)' having the high level VH' may be output from the gate output node GS_ON'.

As such, the gate output circuit 420a may output the gate signal GS(n)' in the second to fourth time periods TP2' to TP4'.

As shown in FIG. 30, in a fifth time period TP5', the input signal FLM/PCR' may have the high level VH', the first clock signal CLK1' may have the low level VL', and the second clock signal CLK2' may have the high level VH'.

When the first clock signal CLK1' has the low level VL', the first switching element T1' may be turned on in response to the first clock signal CLK1'. The sixth switching element T6' may be turned on in response to the gate low voltage VGL, and the first control switching element TC1' may be turned on in response to the enable signal EN' having the low level VL'.

The first switching element T1' may apply the input signal FLM/PCR' to the third node N3' and the first node Q'. Therefore, the third node N3' and the first node Q' may have the low level VL' corresponding to the input signal FLM/PCR'.

The eighth switching element T8' may be turned on in response to the voltage V_Q' of the first node Q' and may apply the second clock signal CLK' having the high level VH' to the gate output node GS ON'. Therefore, the gate signal GS(n)' having the high level VH' may be output from the gate output node GS_ON'.

The first capacitor C1' may store a voltage difference between the voltage of the gate output node GS_ON' and the voltage of the first node Q' .

The fourth switching element T4' may be turned on in response to the first clock signal CLK1' having the low level VL'. The fourth switching element T4' may apply the gate low voltage VGL to the second node QB'. Therefore, the second node QB' may have the low level VL' in response to the gate low voltage VGL.

The seventh switching element T7' may be turned on in response to the voltage V_QB' of the second node QB' and may apply the gate high voltage VGH to the gate output node GS_ON'. Therefore, the gate signal GS(n)' having the high level may be output from the gate output node GS_ON'.

The second capacitor C2' may store a voltage difference between the gate high voltage VGH and the voltage of the second node QB'.

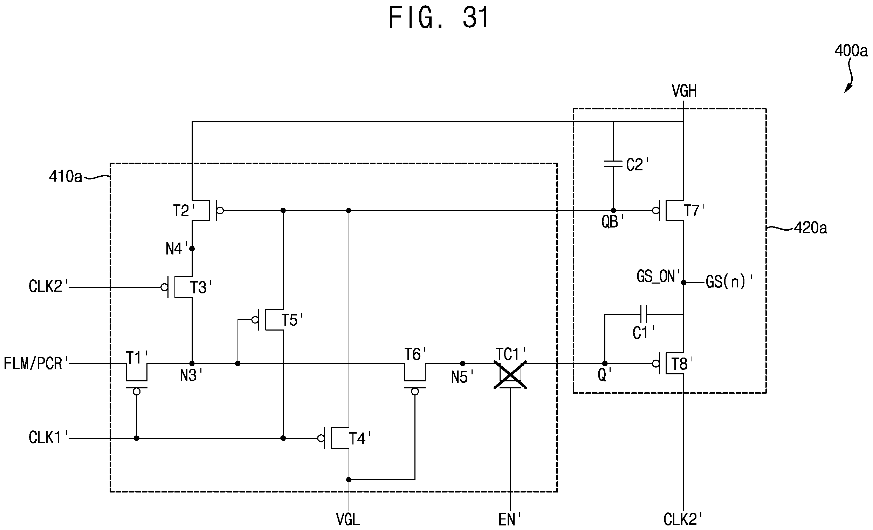

FIG. 31 is a circuit diagram showing an operation of each stage 400a of FIG. 24 when an enable signal EN' has an inactive level.

Referring to FIGS. 24 to 31, the control circuit 410a may include the first control switching element TC1' selectively controlling the voltage V_Q' of the first node Q' in response to the enable signal EN'. The gate output circuit 420a may selectively output the gate signal GS(n)' according to the enable signal EN'.

When the enable signal EN' has the active level, the first control switching element TC1' may transfer the voltage of the third node N3' to the fifth node N5' and the first node Q', and the voltage V_Q' of the first node Q' may be changed according to the input signal FLM/PCR'.

On the other hand, when the enable signal EN' has the inactive level, the first control switching element TC1' may not transfer the voltage of the third node N3' to the fifth node N5' and the first node Q'. The voltage stored by the first capacitor C1' may not be lost. Therefore, the voltage V_Q' of the first node Q' may maintain the high level VH' stored by the first capacitor C1'. The voltage V_QB' of the second node QB' may maintain the low level VL'.

The seventh switching element T7' may be turned on in response to the voltage V_QB' of the second node QB' having the low level VL' and may apply the gate high voltage VGH to the gate output node GS_ON'. Therefore, the gate signal GS(n)' having the high level VH' may be output from the gate output node GS_ON'.

As such, a gate driver 300 and a display device may include a control circuit 410a and a gate output circuit 420a, and the control circuit 410a may include a first control switching element TC1 selectively controlling a voltage V_Q' of the first node Q' in response to an enable signal EN', such that a driving frequency multi-division is supported. Through the driving frequency multi-division, a power consumption of the display device may be effectively reduced.

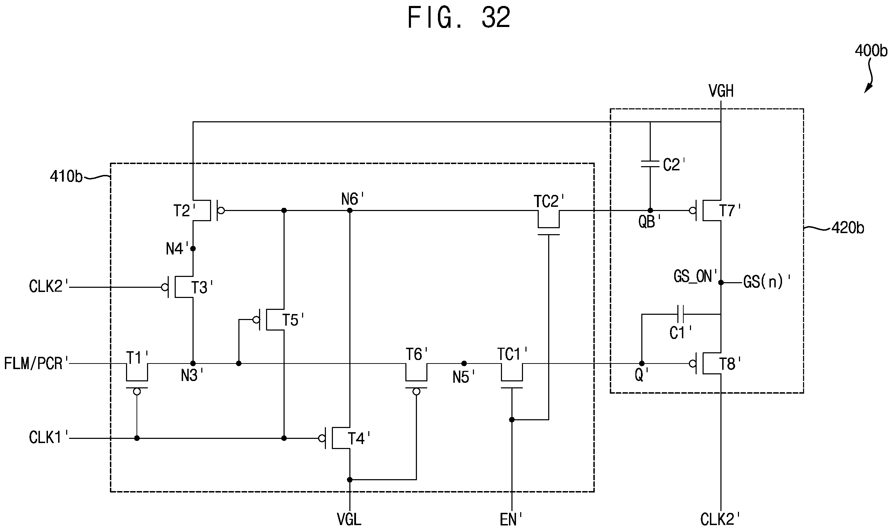

FIG. 32 is a circuit diagram showing still another example of each stage 400b of FIG. 7.

Referring to FIG. 24 and FIG. 32, each stage 400b may include a control circuit 410b and a gate output circuit 420b. The control circuit 410b may control a voltage V_Q' of a first node Q' and a voltage V_QB' of a second node QB' in response to an input signal FLM/PCR', a first clock signal CLK1', and a second clock signal CLK2'. The control circuit 410b may include a first control switching element TC1' selectively connecting the first node Q' and the gate output circuit 420b in response to an enable signal EN', and a second control switching element TC2' selectively connecting the second node QB' and the gate output circuit 420b in response to the enable signal EN'. The gate output circuit 420b may output a gate signal GS(n)' in response to the voltage V_Q' of the first node Q' and the voltage V_QB' of the second node QB'. In an embodiment, the gate signal GS(n)' may be a data writing gate signal GW[n] applied to a pixel.

The stage 400b described with reference to FIG. 32 may be substantially equal to or similar to the stage 400a described with reference to FIG. 24, except that the second control switching element TC2' is added. Accordingly, descriptions of overlapping components are omitted.

The control circuit 410b may include a first switching element T1'. The control circuit 410b may further include a first control switching element TC1'. The control circuit 410b may further include a sixth switching element T6'. The control circuit 410b may further include a second control switching element TC2'. The control circuit 410b may further include a second switching element T2', a third switching element T3', a fourth switching element T4', and a fifth switching element T5'.

The first switching element T1' may include a gate electrode receiving the first clock signal CLK1', a first electrode receiving the input signal FLM/PCR', and a second electrode connected to a third node N3'.

The second switching element T2' may include a gate electrode connected to the sixth node N6', a first electrode receiving a gate high voltage VGH', and a second electrode connected to a fourth node N4'.

The third switching element T3' may include a gate electrode receiving the second clock signal CLK2', a first electrode connected to the fourth node N4', and a second electrode connected to the third node N3'.

The fourth switching element T4' may include a gate electrode receiving the first clock signal CLK1', a first electrode receiving a gate low voltage VGL, and a second electrode connected to the sixth node N6'.

The first control switching element TC1' may include a gate electrode receiving the enable signal EN', a first electrode connected to a fifth node N5', and a second electrode connected to the first node Q'. In an embodiment, the first control switching element TC1' may include a first sub-switching element TS1' and a second sub-switching element TS2'. That is, the first control switching element TC1' may have a dual transistor structure including two transistors.

The second control switching element TC2' may include a gate electrode receiving the enable signal EN', a first electrode connected to the sixth node N6', and a second electrode connected to the second node QB'. In an embodiment, the second control switching element TC2' may include a third sub-switching element TS3' and a fourth sub-switching element TS4'. That is, the second control switching element TC2' may have a dual transistor structure including two transistors.

The fifth switching element T5' may include a gate electrode connected to the third node N3', a first electrode receiving the first clock signal CLK1', and a second electrode connected to the sixth node N6'.

The sixth switching element T6' may include a gate electrode receiving the gate low voltage VGL, a first electrode connected to the third node N3', and a second electrode connected to the fifth node N5'.

The gate output circuit 420b may include a seventh switching element T7' and an eighth switching element T8'. The gate output circuit 420b may further include a first capacitor C1' and a second capacitor C2'.

The seventh switching element T7' may include a gate electrode connected to the second node QB', a first electrode receiving the gate high voltage VGH, and a second electrode connected to a gate output node GS_ON'.

The eighth switching element T8' may include a gate electrode connected to the first node Q', a first electrode receiving the second clock signal CLK2', and a second electrode connected to the gate output node GS_ON'.

The first capacitor C1' may include a first electrode connected to the first node Q' and a second electrode connected to the gate output node GS_ON'. The first capacitor C1' may store a voltage difference between the voltage of the gate output node GS_ON' and the voltage of the first node Q'.

The second capacitor C2' may include a first electrode receiving the gate high voltage VGH and a second electrode connected to the second node QB'. The second capacitor C2' may store a voltage difference between the gate high voltage VGH and the voltage of the second node QB.

A leakage current may be generated more in a P-type transistor than in an N-type transistor. Therefore, some of the switching elements included in each stage 400b may be the N-type transistors. For example, the first control switching element TC1' and the second control switching element TC2' may be the N-type transistors, and the first to eighth switching elements T1' to T8' may be the P-type transistors.

In this embodiment, it is exemplified that some of the switching elements of each stage 400b are the N-type transistors and other some of the switching elements are the P-type transistors, but embodiments of the present invention are not limited thereto. The present invention may also be applied to each stage including only the P-type transistors in another embodiment.

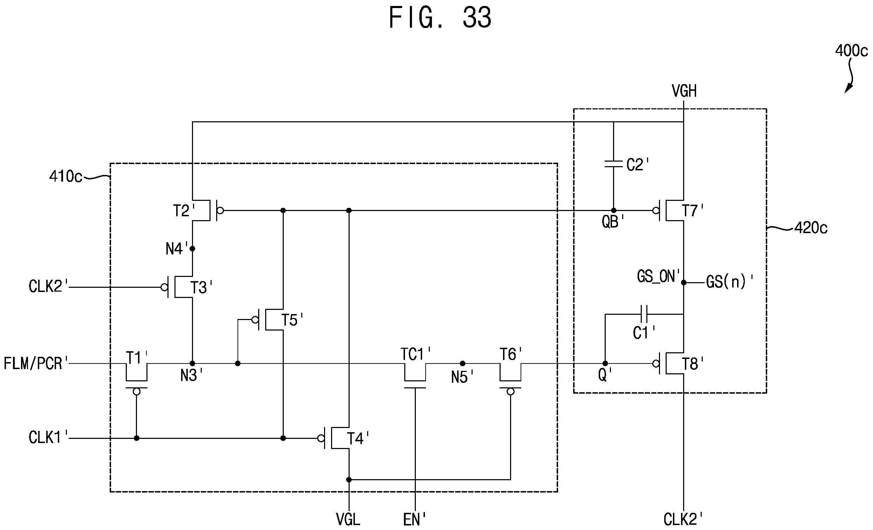

FIG. 33 is a circuit diagram showing yet another example of each stage 400c of FIG. 7.

Referring to FIG. 24 and FIG. 33, each stage 400c may include a control circuit 410c and a gate output circuit 420c. The control circuit 410c may control a voltage V_Q' of a first node Q' and a voltage V_QB' of a second node QB' in response to an input signal FLM/PCR', a first clock signal CLK1', and a second clock signal CLK2'. The control circuit 410c may include a first control switching element TC I' selectively connecting the first node Q' and the gate output circuit 420c in response to an enable signal EN'. The gate output circuit 420c may output a gate signal GS(n)' in response to the voltage V_Q' of the first node Q' and the voltage V_QB' of the second node QB'. In an embodiment, the gate signal GS(n)' may be a data writing gate signal GW[n] applied to a pixel.

The stage 400c described with reference to FIG. 33 may be substantially equal to or similar to the stage 400a described with reference to FIG. 24, except for a position of the first control switching element TC1'. Accordingly, descriptions of overlapping components are omitted.

The control circuit 410c may include a first switching element T1'. The control circuit 410c may further include a first control switching element TC1'. The control circuit 410c may further include a sixth switching element T6'. The control circuit 410c may further include a second switching element T2', a third switching element T3', a fourth switching element T4', and a fifth switching element T5'.

The first switching element T1' may include a gate electrode receiving the first clock signal CLK1', a first electrode receiving the input signal FLM/PCR', and a second electrode connected to a third node N3'.

The second switching element T2' may include a gate electrode connected to the second node QB', a first electrode receiving a gate high voltage VGH, and a second electrode connected to a fourth node N4'.

The third switching element T3' may include a gate electrode receiving the second clock signal CLK2', the first electrode connected to the fourth node N4', and a second electrode connected to the third node N3'.

The fourth switching element T4' may include a gate electrode receiving the first clock signal CLK1', a first electrode receiving a gate low voltage VGL, and a second electrode connected to the second node QB'.

The first control switching element TC1' may include a gate electrode receiving the enable signal EN', a first electrode connected to the third node N3', and a second electrode connected to the fifth node N5'. In an embodiment, the first control switching element TC1' may include a first sub-switching element TS1' and a second sub-switching element TS2'. That is, the first control switching element TC1' may have a dual transistor structure including two transistors.

The fifth switching element T5' may include a gate electrode connected to the third node N3', a first electrode receiving the first clock signal CLK1', and a second electrode connected to the second node QB'.

The sixth switching element T6' may include a gate electrode receiving the gate low voltage VGL, a first electrode connected to the fifth node N5', and a second electrode connected to the first node Q'.

The gate output circuit 420c may include a seventh switching element T7' and an eighth switching element T8'. The gate output circuit 420c may further include a first capacitor C1' and a second capacitor C2'.

The seventh switching element T7' may include a gate electrode connected to the second node QB', a first electrode receiving the gate high voltage VGH, and a second electrode connected to a gate output node GS_ON'.

The eighth switching element T8' may include a gate electrode connected to the first node Q', a first electrode receiving the second clock signal CLK2', and a second electrode connected to the gate output node GS_ON'.

The first capacitor C1' may include a first electrode connected to the first node Q' and a second electrode connected to the gate output node GS_ON'. The first capacitor C1' may store a voltage difference between the voltage of the gate output node GS_ON' and the voltage of the first node Q'.

The second capacitor C2' may include a first electrode receiving the gate high voltage VGH and a second electrode connected to the second node QB'. The second capacitor C2' may store a voltage difference between the gate high voltage VGH and the voltage of the second node QB'.

A leakage current may be generated more in a P-type transistor than in an N-type transistor. Therefore, some of the switching elements included in each stage 400c may be the N-type transistor. For example, the first control switching element TC1' may be the N-type transistor, and the first to eighth switching elements T1' to T8' may be the P-type transistors.

In this embodiment, it is exemplified that some of the switching elements of each stage 400c are the N-type transistors, and other some of the switching elements are the P-type transistors, but embodiments of the present invention are not limited thereto. The present invention may also be applied to each stage including only the P-type transistors in another embodiment.

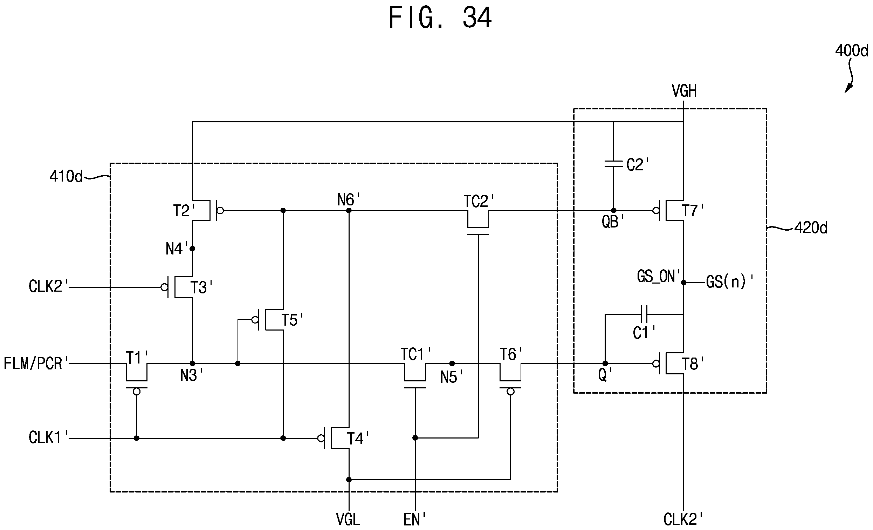

FIG. 34 is a circuit diagram showing still another example of each stage 400d of FIG. 7.

Referring to FIG. 24 and FIG. 34, each stage 400d may include a control circuit 410d and a gate output circuit 420d. The control circuit 410d may control a voltage V_Q' of a first node Q' and a voltage V_QB' of a second node QB' in response to an input signal FLM/PCR', a first clock signal CLK1', and a second clock signal CLK2'. The control circuit 410d may include a first control switching element TC1' selectively connecting the first node Q' and the gate output circuit 420d in response to an enable signal EN' and a second control switching element TC2' selectively connecting the second node QB' and the gate output circuit 420d in response to the enable signal EN'. The gate output circuit 420d may output a gate signal GS(n)' in response to the voltage V_Q' of the first node Q' and the voltage V_QB' of the second node QB'. In an embodiment, the gate signal GS(n)' may be a data writing gate signal GW[n] applied to a pixel.

The stage 400d described with reference to FIG. 34 may be substantially equal to or similar to the stage 400a described with reference to FIG. 24, except for a position of the first control switching element TC1' and an addition of the second control switching element TC2'. Accordingly, the description of the overlapping components is omitted.

The control circuit 410d may include a first switching element T1'. The control circuit 410d may further include a first control switching element TC1'. The control circuit 410d may further include a sixth switching element T6'. The control circuit 410d may further include a second control switching element TC2'. The control circuit 410d may further include a second switching element T2', a third switching element T3', a fourth switching element T4', and a fifth switching element T5'.

The first switching element T1' may include a gate electrode receiving the first clock signal CLK1', a first electrode receiving the input signal FLM/PCR', and a second electrode connected to a third node N3'.

The second switching element T2' may include a gate electrode connected to a sixth node N6', a first electrode receiving a gate high voltage VGH, and a second electrode connected to a fourth node N4'.

The third switching element T3' may include a gate electrode receiving the second clock signal CLK2', the first electrode connected to the fourth node N4', and a second electrode connected to the third node N3'.

The fourth switching element T4' may include a gate electrode receiving the first clock signal CLK1', a first electrode receiving a gate low voltage VGL, and a second electrode connected to the sixth node N6'.

The first control switching element TC1' may include a gate electrode receiving the enable signal EN', a first electrode connected to the third node N3', and a second electrode connected to the fifth node N5'. In an embodiment, the first control switching element TC1' may include a first sub-switching element TS1' and a second sub-switching element TS2'. That is, the first control switching element TC1' may have a dual transistor structure including two transistors.

The second control switching element TC2' may include a gate electrode receiving the enable signal EN', a first electrode connected to the sixth node N6', and a second electrode connected to the second node QB'. In an embodiment, the second control switching element TC2' may include a third sub-switching element TS3' and a fourth sub-switching element TS4'. That is, the second control switching element TC2' may have a dual transistor structure including two transistors.

The control circuit 410e may further include a fifth switching element T5' and a sixth switching element T6'.

The fifth switching element T5' may include a gate electrode connected to the third node N3', a first electrode receiving the first clock signal CLK1', and a second electrode connected to the sixth node N6'.

The sixth switching element T6' may include a gate electrode receiving the gate low voltage VGL, a first electrode connected to the fifth node N5', and a second electrode connected to the first node Q'.

The second control switching element TC2' may include a gate electrode receiving the enable signal EN', a first electrode connected to the sixth node N6', and a second electrode connected to the second node QB'.

The gate output circuit 420d may include a seventh switching element T7' and an eighth switching element T8'. The gate output circuit 420d may further include a first capacitor C1' and a second capacitor C2'.

The seventh switching element T7' may include a gate electrode connected to the second node QB', a first electrode receiving the gate high voltage VGH, and a second electrode connected to the gate output node GS_ON'.

The eighth switching element T8' may include a gate electrode connected to the first node Q', a first electrode receiving the second clock signal CLK2', and a second electrode connected to the gate output node GS_ON'.

The first capacitor C1' may include a first electrode connected to the first node Q' and a second electrode connected to the gate output node GS _ON'. The first capacitor C1' may store a voltage difference between the voltage of the gate output node GS_ON' and the voltage of the first node Q'.

The second capacitor C2' may include a first electrode receiving the gate high voltage VGH and a second electrode connected to the second node QB'. The second capacitor C2' may store a voltage difference between the gate high voltage VGH and the voltage of the second node QB'.

A leakage current may be generated more in a P-type transistor than in an N-type transistor. Therefore, some of the switching elements included in each stage 400d may be the N-type transistors. For example, the first control switching element TC1' and the second control switching element TC2' may be the N-type transistors, and the first to eighth switching elements T1' to T8' may be the P-type transistors.

In this embodiment, it is exemplified that some of the switching elements of each stage 400d are the N-type transistors and other some of the switching elements are the P-type transistors, but embodiments of the present invention are not limited thereto. The present invention may also be applied to each stage including only the P-type transistors in another embodiment.

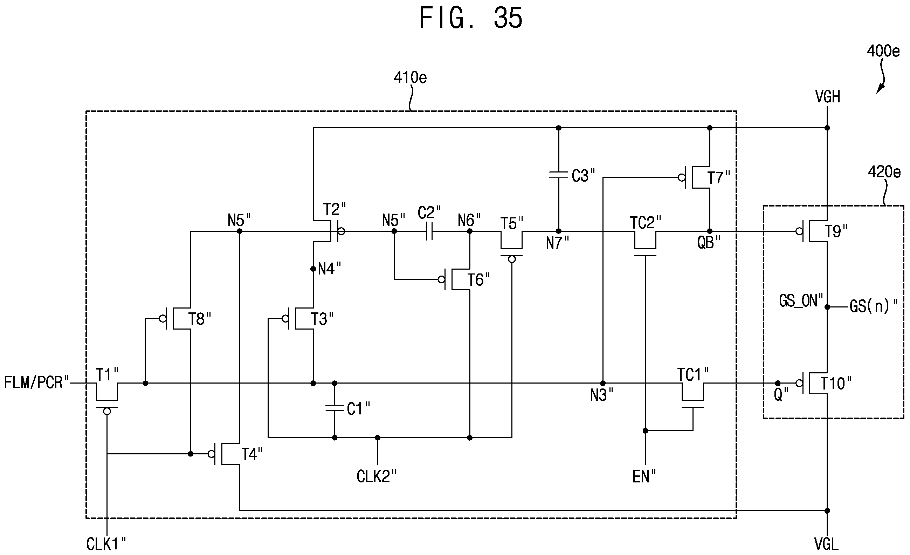

FIG. 35 is a circuit diagram showing yet another example 400e of each stage of FIG. 7.

Referring to FIG. 35, each stage 400e may include a control circuit 410e and a gate output circuit 420e. The control circuit 410e may control a voltage V_Q" of a first node Q" and a voltage V_QB" of a second node QB" in response to an input signal FLM/PCR", a first clock signal CLK1", and a second clock signal CLK2". The control circuit 410e may include a first control switching element TC1" selectively connecting the first node Q" and the gate output circuit 420e in response to an enable signal EN" and a second control switching element TC2" selectively connecting the second node QB" and the gate output circuit 420e in response to the enable signal EN". The gate output circuit 420e may output a gate signal GS(n)" in response to the voltage V_Q" of the first node Q" and the voltage V_Q" of the second node QB". In an embodiment, the gate signal GS(n)" may be one of a compensation gate signal GC[n] and a data initialization gate signal GI[n] applied to a pixel.

The control circuit 410e may include a first switching element T1". The control circuit 410e may further include a first control switching element TC1". The control circuit 410e may further include a second control switching element TC2". The control circuit 410e may further include a second switching element T2", a third switching element T3", a fourth switching element T4", a fifth switching element T5", a sixth switching element T6", a seventh switching element T7", an eighth switching element T8", a first capacitor C1, a second capacitor C2, and a third capacitor C3.

The first switching element T1" may include a gate electrode receiving the first clock signal CLK1", a first electrode receiving the input signal FLM/PCR", and a second electrode connected to a third node N3".

The second switching element T2" may include a gate electrode connected to a fifth node N5", a first electrode receiving a gate high voltage VGH, and a second electrode connected to a fourth node N4".

The third switching element T3" may include a gate electrode receiving the second clock signal CLK2", a first electrode connected to the fourth node N4", and a second electrode connected to the third node N3".

The fourth switching element T4" may include a gate electrode receiving the first clock signal CLK1", a first electrode receiving a gate low voltage VGL, and a second electrode connected to the fifth node N5".

The fifth switching element T5" may include a gate electrode receiving the second clock signal CLK2", a first electrode connected to the sixth node N6", and a second electrode connected to the seventh node N7".

The sixth switching element T6" may include a gate electrode connected to the fifth node N5", a first electrode receiving the second clock signal CLK2", and a second electrode connected to the sixth node N6".

The seventh switching element T7" may include a gate electrode connected to the third node N3", a first electrode receiving the gate high voltage VGH, and a second electrode connected to the second node QB".

The first control switching element TC1" may include a gate electrode receiving the enable signal EN", a first electrode connected to the third node N3", and a second electrode connected to the first node Q".

The second control switching element TC2" may include a gate electrode receiving the enable signal EN", a first electrode connected to the seventh node N7", and a second electrode connected to the second node QB".

The eighth switching element T8" may include a gate electrode connected to the third node N3", a first electrode receiving the first clock signal CLK1", and a second electrode connected to the fifth node N5".

The first capacitor C1" may include a first electrode receiving the second clock signal CLK2" and a second electrode connected to the third node N3". The first capacitor C1" may store a voltage difference between the voltage of the gate output node GS_ON" and a voltage of the third node N3".

The second capacitor C2" may include a first electrode connected to the fifth node N5" and a second electrode connected to the sixth node N6". The second capacitor C2" may store a voltage difference between the voltage of the fifth node N5" and the voltage of the sixth node N6".

The third capacitor C3" may include a first electrode receiving the gate high voltage VGH and a second electrode connected to the seventh node N7". The third capacitor C3" may store a voltage difference between the gate high voltage VGH and a voltage of the seventh node N7".

The gate output circuit 420e may include a ninth switching element T9" and a tenth switching element T10".

The ninth switching element T9" may include a gate electrode connected to the second node QB", a first electrode receiving the gate high voltage VGH, and a second electrode connected to a gate output node GS_ON".

The tenth switching element T10" may include a gate electrode connected to the first node Q", a first electrode receiving the gate low voltage VGL, and a second electrode connected to the gate output node GS_ON".

A leakage current may be generated more in a P-type transistor than in an N-type transistor. Therefore, some of the switching elements included in each stage 400e may be the N-type transistors. For example, the first control switching element TC1" and the second control switching element TC2" may be the N-type transistors, and the first to tenth switching elements T1" to T10" may be the P-type transistors.

In this embodiment, it is exemplified that some of the switching elements of each stage 400e are the N-type transistors, and other some of the switching elements are the P-type transistors, but embodiments of the present invention are not limited thereto. The present invention may also be applied to each stage including only the P-type transistors in another embodiment.

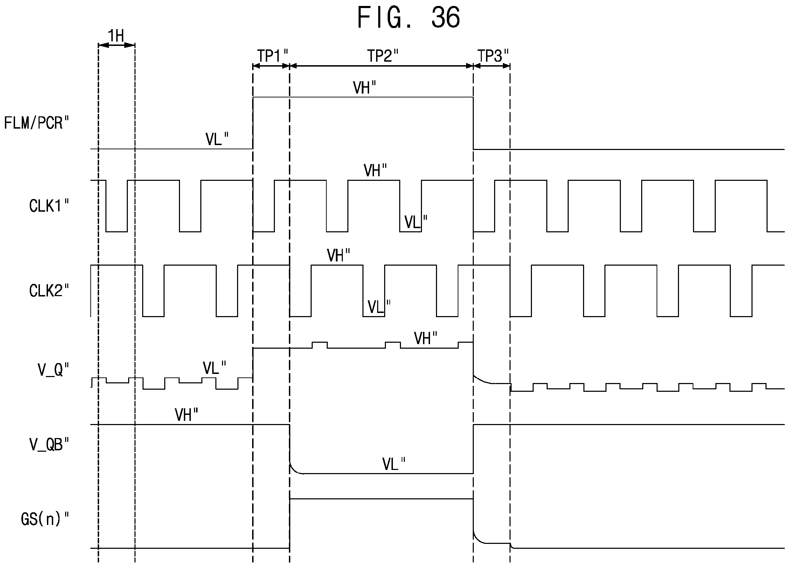

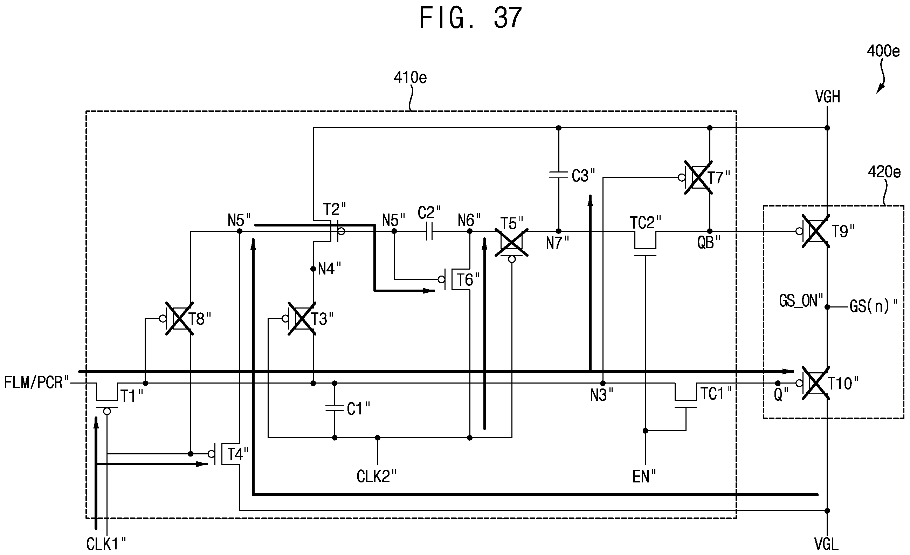

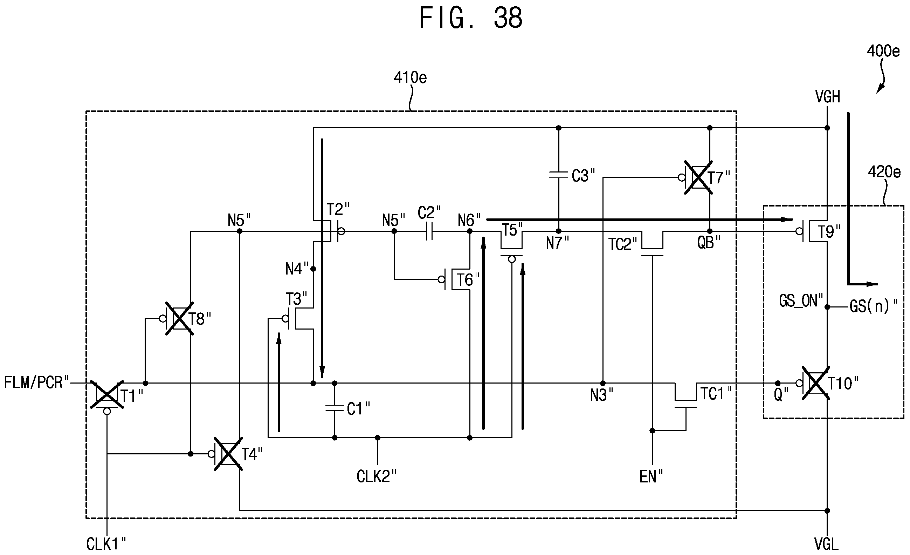

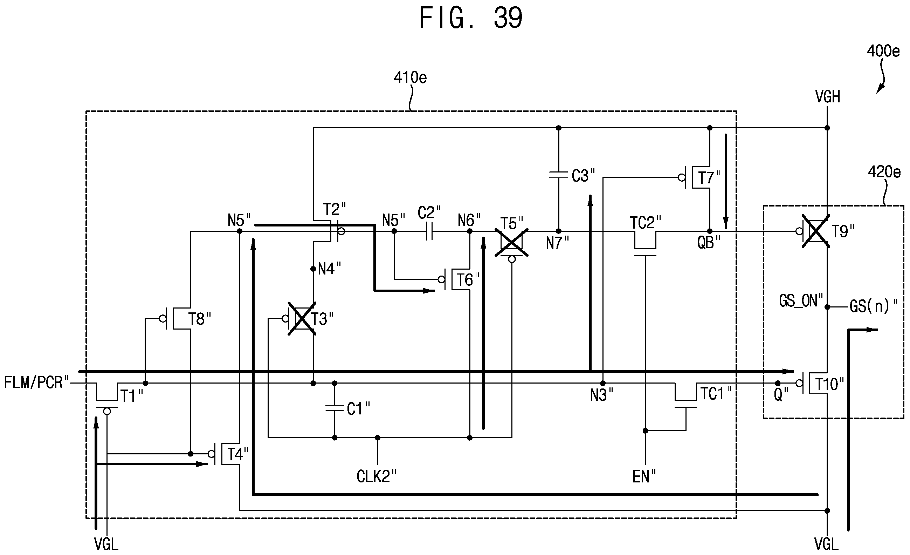

FIG. 36 is a timing diagram showing an input signal FLM/PCR", a first clock signal CLK1", a second clock signal CLK2", node signals V_Q", V_QB", and an output signal GS(n)" of each stage 400e of FIG. 35. FIG. 37 is a circuit diagram showing an operation of each stage 400e of FIG. 35 in a first time period TP1" of FIG. 36. FIG. 38 is a circuit diagram showing an operation of each stage 400e of FIG. 35 in a second time period TP2" of FIG. 36. FIG. 39 is a circuit diagram showing an operation of each stage 400e of FIG. 35 in a third time period TP3" of FIG. 36.

Referring to FIGS. 35 to 39, an operation of each stage 400e is explained when the first control switching element TC1" and the second control switching element TC2" maintain a turn-on state in response to the enable signal EN" having an active level.

As shown in FIG. 31, in a first time period TP1", an input signal FLM/PCR" may have a high level VH", a first clock signal CLK1" may maintain a low level VL" and then change from the low level VL" to the high level VH", and a second clock signal CLK2" may have the high level VH".

The first switching element T1" may be turned on in response to the first clock signal CLK1" having the low level VL". The first switching element T1" may apply the input signal FLM/PCR" having the high level VH" to the third node N3" and the first node Q", and the first capacitor C1" may be charged.

The fourth switching element T4" may be turned on in response to the first clock signal CLK1" having the low level VL". The fourth switching element T4" may apply the gate low voltage VGL to the fifth node N5".

The sixth switching element T6" may be turned on in response to a voltage of the fifth node N5" having the gate low voltage VGL. The sixth switching element T6" may apply the second clock signal CLK2" having the high level VH" to the sixth node N6", and the second capacitor C2" may be charged.

As shown in FIG. 32, in a second time period TP2", the input signal FLM/PCR" may have the high level VH", the first clock signal CLK1" may alternately have the high level VH" and the low level VL", and the second clock signal CLK2" may alternately have the high level VH" and the low level VL".

The third switching element T3" may be turned on in response to the second clock signal CLK2" having the low level VL". The second switching element T2" may maintain a turn-on state in response to the fifth node N5" having the low level VL". The gate high voltage VGH may be applied to the third node N3" and the first node N1" through the second switching element T2" and the third switching element T3".

The fifth switching element T5" may be turned on in response to the second clock signal CLK2" having the low level VL". The sixth switching element T6" may be maintained in a turn-on state in response to the fifth node N5" having the low level VL". The second clock signal CLK2" having the low level VL" may be applied to the seventh node N7" and the second node N2" through the sixth switching element T6 and the fifth switching element T5", and the third capacitor C3" may be charged. Therefore, the ninth switching element T9" may be turned on in response to the voltage V_QB" of the second node QB" having the low level VL" and may apply the gate high voltage VGH to the gate output node GS_ON". Accordingly, the gate signal GS(n)" having the high level VH" may be output from the gate output node GS_ON".

As shown in FIG. 33, in a third time period TP3", the input signal FLM/PCR" may have the low level VL", the first clock signal CLK1" may maintain the low level VL" and then change to the high level VH‴, and the second clock signal CLK2" may have the high level VH".

The first switching element T1" may be turned on in response to the first clock signal CLK1" having the low level VL". The first switching element T1" may apply the input signal FLM/PCR" having the low level VL" to the third node N3" and the first node Q", and the first capacitor C1" may be charged. The tenth switching element T10" may be turned on in response to the voltage V_Q" of the first node Q" having the low level VL" and may apply the gate low voltage VGL to the gate output node GS_ON". Therefore, the gate signal GS(n)" having the low level VL" may be output from the gate output node GS_ON".

The fourth switching element T4" may be turned on in response to the first clock signal CLK1" having the low level VL". The fourth switching element T4" may apply the gate low voltage VGL to the fifth node N5.

The sixth switching element T6" may be turned on in response to a voltage of the fifth node N5" having the gate low voltage VGL. The sixth switching element T6" may apply the second clock signal CLK2" having the high level VH" to the sixth node N6", and the second capacitor C2" may be charged.

As such, the gate output circuit 420e may output the gate signal GS(n)" in the second time period TP2".

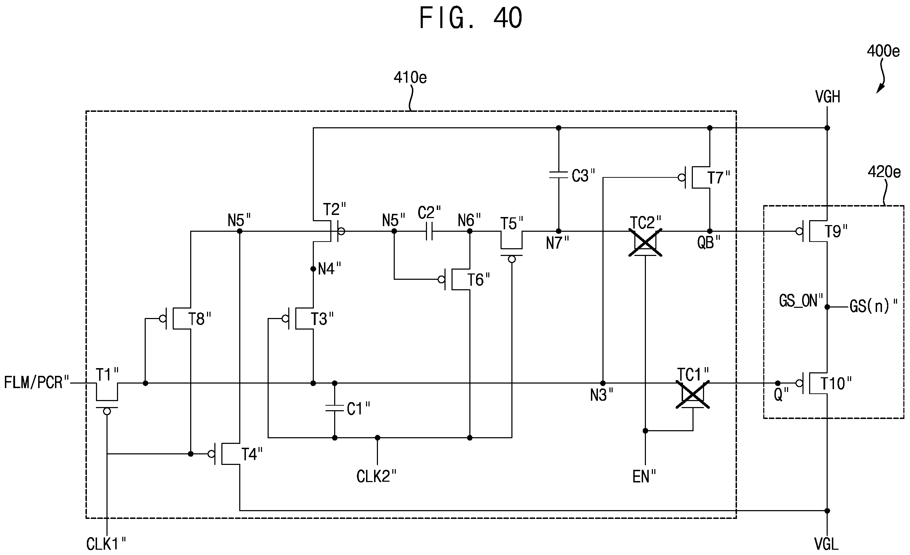

FIG. 40 is a circuit diagram showing an operation of each stage 400e of FIG. 35 when an enable signal EN" has an inactive level.

Referring to FIGS. 35 to 40, the control circuit 410e may include the first control switching element TC1" selectively controlling the voltage V_Q" of the first node Q" in response to the enable signal EN" and the second control switching element TC2" selectively controlling the voltage V_QB" of the second node QB". The gate output circuit 420e may selectively output the gate signal GS(n)" according to the enable signal EN".

When the enable signal EN" has the active level, the first control switching element TC1" may transfer a voltage of the third node N3" to the first node Q", and the voltage V_Q" of the first node Q" may be changed according to the input signal FLM/PCR".

On the other hand, when the enable signal EN" has the inactive level, the first control switching element TC1' may not transfer the voltage of the third node N3' to the fifth node N5' and the first node 'Q'.

Since the first control switching element TC1" may be turned off in response to the enable signal EN" having the low level VL", the input signal FLM/PCR" may not be applied to the first node Q". Therefore, the voltage V_Q" of the first node Q" may maintain the low level VL" stored by the first capacitor C1". The voltage V_QB" of the second node QB" may maintain the high level VH".

The tenth switching element T10" may be turned on in response to the voltage V_QB" of the first node Q" having the low level VL" and may apply the gate low voltage VGL to the gate output node GS_ON". Therefore, the gate signal GS(n)" having the low level VL" may be output from the gate output node GS_ON".

As such, a gate driver 300 and a display device may include a control circuit 410e and a gate output circuit 420e, and the control circuit 410e may include a first control switching element TC1" selectively controlling a voltage V_Q" of a first node Q" in response to an enable signal EN", such that a driving frequency multi-division is supported. Through the driving frequency multi-division, a power consumption of the display device may be effectively reduced.

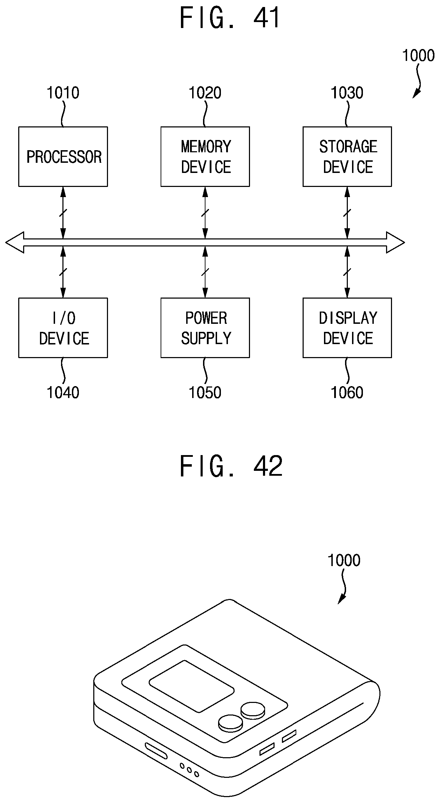

FIG. 41 is a block diagram showing an electronic device 1000. FIG. 42 is a diagram showing an embodiment in which an electronic device 1000 of FIG. 41 is implemented as a smart phone.

Referring to FIGS. 41 and 42, the electronic device 1000 may include a processor 1010, a memory device 1020, a storage device 1030, an input/output I/O device 1040, a power supply 1050, and a display device 1060. The display device 1060 may be the display device of FIG. 1. In addition, the electronic device 1000 may further include a plurality of ports for communicating with a video card, a sound card, a memory card, a universal serial bus USB device, other electronic device, and/or the like.

In an embodiment, as illustrated in FIG. 42, the electronic device 1000 may be implemented as the smart phone. However, the electronic device 1000 is not limited thereto. For another example, the electronic device 1000 may be implemented as a cellular phone, a video phone, a smart pad, a smart watch, a tablet PC, a car navigation system, a computer monitor, a laptop, a head mounted display ("HMD") device, and/or the like.

The processor 1010 may perform various computing functions. The processor 1010 may be a microprocessor, a central processing unit ("CPU"), an application processor ("AP"), and/or the like. The processor 1010 may be coupled to other components via an address bus, a control bus, a data bus, and/or the like. Further, the processor 1010 may be coupled to an extended bus such as a peripheral component interconnection ("PCI") bus.

The memory device 1020 may store data for operations of the electronic device 1000. For example, the memory device 1020 may include at least one nonvolatile memory device such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM") device, a ferroelectric random access memory ("FRAM") device, and/or the like and/or at least one volatile memory device such as a dynamic random access memory ("DRAM") device, a static random access memory ("SRAM") device, a mobile ("DRAM") device, and/or the like.

The storage device 1030 may include a solid-state drive ("SSD") device, a hard disk drive ("HDD") device, a CD-ROM device, and/or the like.

The I/O device 1040 may include an input device such as a keyboard, a keypad, a mouse device, a touchpad, a touchscreen, and/or the like, and an output device such as a printer, a speaker, and/or the like. In some embodiments, the I/O device 1040 may include the display device 1060.

The power supply 1050 may provide power for operations of the electronic device 1000.

The display device 1060 may be connected to other components through buses or other communication links.

As discussed, embodiments can provide a gate driver including a plurality of stages, wherein each of the stages comprises: a control circuit configured to control a voltage of a first node and a voltage of a second node in response to an input signal, a first clock signal, and a second clock signal; and a gate output circuit configured to output a gate signal in response to the voltage of the first node and the voltage of the second node, wherein the control circuit includes a first control switching element configured to selectively connect the first node and the gate output circuit in response to an enable signal.

In some embodiment, the gate driver may support driving frequency multi-division.

The enable signal may be provided to each of the plurality of stages.

The enable signal may be provided to a line connected to the first control switching element to control the on/off state of the first control switching element. The first control switching element may be a transistor and the enable signal may be provided to a line connected to the gate of the first control switching element.

The first control switching element may be a dual transistor arrangement and the enable signal may be provided to a line connected to the gates of the first control switching element.

The first node and the second node may correspond to output notes.

The first node may be connected to a switching element in the gate output circuit (e.g. to the gate of a transistor). The second node may be connected to another switching element in the gate output circuit (e.g. to the gate of a transistor). These switching elements may be connected between a line proving the first clock signal and a voltage line. An output of the gate output circuit may be connected to a node between these switching elements.

Embodiments can provide a display device and an electronic device comprising the gate driver.

The inventions may be applied to any display device and any electronic device including the touch panel. For example, the inventions may be applied to a mobile phone, a smart phone, a tablet computer, a digital television ("TV"), a 3D TV, a personal computer ("PC"), a home appliance, a laptop computer, a personal digital assistant ("PDA"), a portable multimedia player PMP, a digital camera, a music player, a portable game console, a navigation device, etc.

The foregoing is illustrative of the invention and is not to be construed as limiting thereof. Although a few embodiments of the invention have been described, those skilled in the art will readily appreciate that many modifications are possible in the embodiments without materially departing from the novel teachings and advantages of the invention. Accordingly, all such modifications are intended to be included within the scope of the invention as defined in the claims. In the claims, means-plus-function clauses are intended to cover the structures described herein as performing the recited function and not only structural equivalents but also equivalent structures. Therefore, it is to be understood that the foregoing is illustrative of the invention and is not to be construed as limited to the specific embodiments disclosed, and that modifications to the disclosed embodiments, as well as other embodiments, are intended to be included within the scope of the appended claims. The invention is defined by the following claims, with equivalents of the claims to be included therein.

## Claims

1. A gate driver (300) including a plurality of stages (400), wherein each of the stages comprises:
a control circuit (410) configured to control a voltage of a first node (Q, Q', Q") and a voltage of a second node (QB, QB', QB") in response to an input signal, a first clock signal, and a second clock signal; and
a gate output circuit (420) configured to output a gate signal in response to the voltage of the first node and the voltage of the second node,
wherein the control circuit includes a first control switching element (TC1) configured to selectively connect the first node and the gate output circuit in response to an enable signal.

2. The gate driver of claim 1, wherein the gate output circuit is configured to selectively output the gate signal in response to the enable signal.

3. The gate driver of claim 2, wherein, when the enable signal has an inactive level which turns off the first control switching element before the input signal has a high level, a gate signal having a low level is output, and
wherein, when the enable signal has the inactive level after the input signal has the high level, a gate signal having the high level is output.

4. The gate driver of claim 2 or 3, wherein, when the enable signal has an inactive level which turns off the first control switching element before the input signal has a low level, a gate signal having a high level is output, and
wherein, when the enable signal has the inactive level after the input signal has the low level, a gate signal having the low level is output.

5. The gate driver of any one of claims 2 to 4, wherein the gate signal is at least one of a data writing gate signal, a compensation gate signal, and a data initialization gate signal, which are applied to the pixel, and
wherein a data voltage is applied to the pixel in response to the data writing gate signal,
a threshold voltage of a driving transistor (PT1) included in the pixel is compensated in response to the compensation gate signal, and
the driving transistor is initialized in response to the data initialization gate signal.

6. The gate driver of claim 5, wherein the pixel includes:
a first transistor (PT1), which is the driving transistor, including a gate electrode connected to a first pixel node (PN1), a first electrode connected to a second pixel node (PN2), and a second electrode connected to a third pixel node (PN3);
a second transistor (PT2) including a gate electrode to which the data writing gate signal is applied, a first electrode to which the data voltage is applied, and a second electrode connected to the second pixel node;
a third transistor (PT3) including a gate electrode to which the compensation gate signal is applied, a first electrode connected to the first pixel node, and a second electrode connected to the third pixel node;
a fourth transistor (PT4) including a gate electrode to which the data initialization gate signal is applied, a first electrode to which an initialization voltage is applied, and a second electrode connected to the first pixel node;
a fifth transistor (PT5) including a gate electrode to which an emission signal is applied, a first electrode to which a first driving voltage is applied, and a second electrode connected to the second pixel node;
a seventh transistor (PT7) including a gate electrode to which a light-emitting element initialization gate signal is applied, a first electrode to which a light-emitting element initialization voltage is applied, and a second electrode connected to an anode electrode of a light-emitting element; and
the light-emitting element (EE) including the anode electrode and a cathode electrode to which a second driving voltage is applied.

7. The gate driver of any one of claims 1 to 6, wherein the first control switching element includes a gate electrode configured to receive the enable signal, a first electrode connected to a third node (N3), and a second electrode connected to a fifth node (N5), and
wherein the control circuit further includes:
a first switching element (T1) including a gate electrode configured to receive the first clock signal, a first electrode configured to receive the input signal, and a second electrode connected to the third node;
a second switching element (T2) including a gate electrode connected to the first node, a first electrode configured to receive the second clock signal, and a second electrode connected to a fourth node (N4);
a ninth switching element (T9) including a gate electrode configured to receive a gate low voltage, a first electrode connected to the fifth node, and a second electrode connected to the first node; and
a third capacitor (C3) including a first electrode connected to the fourth node and a second electrode connected to the first node.

8. The gate driver of claim 7, wherein the control circuit further includes:
a third switching element (T3) including a gate electrode configured to receive the first clock signal, a first electrode configured to receive the gate low voltage, and a second electrode connected to a sixth node (N6);
a fourth switching element (T4) including a gate electrode configured to receive the gate low voltage, a first electrode connected to the sixth node, and a second electrode connected to a seventh node (N7);
a fifth switching element (T5) including a gate electrode connected to the first node, a first electrode configured to receive the first clock signal, and a second electrode connected to the sixth node;
a sixth switching element (T6) including a gate electrode connected to the seventh node, a first electrode configured to receive the second clock signal, and a second electrode connected to an eighth node (N8);
a seventh switching element (T7) including a gate electrode configured to receive the second clock signal, a first electrode connected to the eighth node, and a second electrode connected to the second node;
an eighth switching element (T8) including a gate electrode connected to the first node, a first electrode configured to receive the first clock signal, and a second electrode connected to the second node;
a first capacitor (C1) including a first electrode configured to receive the first clock signal and a second electrode connected to the second node; and
a second capacitor (C2) including a first electrode connected to the seventh node and a second electrode connected to the eighth node;
optionally wherein the gate output circuit includes: a tenth switching element (T10) including a gate electrode connected to the second node, a first electrode configured to receive the first clock signal, and a second electrode connected to a gate output node (GS_ON); and an eleventh switching element (T11) including a gate electrode connected to the first node, a first electrode configured to receive the gate low voltage, and a second electrode connected to the gate output node.

9. The gate driver of any one of claims 1 to 6, wherein the control circuit includes:
a first switching element (T1') including a gate electrode configured to receive the first clock signal, a first electrode configured to receive the input signal, and a second electrode connected to a third node (N3'), and
the gate output circuit further includes:
a seventh switching element (T7') including a gate electrode connected to the second node, a first electrode configured to receive a gate high voltage, and a second electrode connected to a gate output node (GS _ON'); and
an eighth switching element (T8') including a gate electrode connected to the first node, a first electrode configured to receive the second clock signal, and a second electrode connected to the gate output node;
optionally wherein the first control switching element includes a gate electrode configured to receive the enable signal, a first electrode connected to a fifth node, and a second electrode connected to the first node;
optionally wherein the control circuit further includes: a sixth switching element (T6') including a gate electrode configured to receive a gate low voltage, a first electrode connected to the third node, and a second electrode connected to the fifth node;
optionally wherein the control circuit further includes: a second switching element (T2') including a gate electrode connected to the second node, a first electrode configured to receive the gate high voltage, and a second electrode connected to a fourth node (N4'); a third switching element (T3') including a gate electrode configured to receive the second clock signal, a first electrode connected to the fourth node, and a second electrode connected to the third node; a fourth switching element (T4') including a gate electrode configured to receive the first clock signal, a first electrode configured to receive the gate low voltage, and a second electrode connected to the second node; and a fifth switching element (T5') including a gate electrode connected to the third node, a first electrode configured to receive the first clock signal, and a second electrode connected to the second node, and the gate output circuit further includes: a first capacitor (C1') including a first electrode connected to the first node and a second electrode connected to the gate output node; and a second capacitor (C2') including a first electrode configured to receive the gate high voltage and a second electrode connected to the second node.

10. The gate driver of any one of claims 1 to 9, wherein the first control switching element has a dual transistor structure including two transistors; and/or
wherein the first control switching element is an N-type transistor.

11. The gate driver of any one of claims 1 to 10, wherein the control circuit further includes:
a second control switching element (TC2) configured to selectively connect the second node and the gate output circuit in response to the enable signal.

12. The gate driver of claim 11, wherein the control circuit further includes:
a first switching element (T1') including a gate electrode configured to receive the first clock signal, a first electrode configured to receive the input signal, and a second electrode connected to a third node (N3'), and
the gate output circuit includes:
a seventh switching element (T7') including a gate electrode connected to the second node, a first electrode configured to receive the gate high voltage, and a second electrode connected to a gate output node (GS _ON'); and
an eighth switching element (T8') including a gate electrode connected to the first node, a first electrode configured to receive the second clock signal, and a second electrode connected to the gate output node;
optionally wherein the first control switching element includes a gate electrode configured to receive the enable signal, a first electrode connected to a fifth node (N5'), and a second electrode connected to the first node;
optionally wherein the second control switching element includes a gate electrode configured to receive the enable signal, a first electrode connected to a sixth node (N6'), and a second electrode connected to the second node;
optionally wherein the control circuit further includes: a sixth switching element (T6') including a gate electrode configured to receive a gate low voltage, a first electrode connected to the third node, and the second electrode connected to the fifth node;
optionally wherein the control circuit further includes: a second switching element (T2') including a gate electrode connected to the sixth node, a first electrode configured to receive the gate high voltage, and a second electrode connected to the fourth node; a third switching element (T3') including a gate electrode configured to receive the second clock signal, the first electrode connected to the fourth node, and a second electrode connected to the third node; a fourth switching element (T4') including a gate electrode configured to receive the first clock signal, a first electrode configured to receive the gate low voltage, and a second electrode connected to the sixth node; and a fifth switching element (T5') including a gate electrode connected to the third node, a first electrode configured to receive the first clock signal, and a second electrode connected to the sixth node; and the gate output circuit further includes: a first capacitor (C1') including a first electrode connected to the first node and a second electrode connected to the gate output node; and a second capacitor (C2') including a first electrode configured to receive the gate high voltage and a second electrode connected to the second node.

13. The gate driver of claim 11, wherein the control circuit includes:
a first switching element (T1") including a gate electrode configured to receive the first clock signal, a first electrode configured to receive the input signal, and a second electrode connected to a third node (N3"), and
the gate output circuit includes:
a ninth switching element (T9") including a gate electrode connected to the second node, a first electrode configured to receive a gate high voltage, and a second electrode connected to a gate output node (GS _ON"); and
a tenth switching element (T10") including a gate electrode connected to the first node, a first electrode configured to receive a gate low voltage, and a second electrode connected to the gate output node;
optionally wherein the first control switching element includes a gate electrode configured to receive the enable signal, a first electrode connected to the third node, and a second electrode connected to the first node;
optionally wherein the second control switching element includes a gate electrode configured to receive the enable signal, a first electrode connected to a seventh node (N7"), and a second electrode connected to the second node;
optionally wherein the control circuit further includes: a second switching element (T2") including a gate electrode connected to a fifth node (N5"), a first electrode configured to receive the gate high voltage, and a second electrode connected to a fourth node (N4"); a third switching element (T3") including a gate electrode configured to receive the second clock signal, a first electrode connected to the fourth node, and a second electrode connected to the third node; a fourth switching element (T4") including a gate electrode configured to receive the first clock signal, a first electrode configured to receive the gate low voltage, and a second electrode connected to the fifth node; a fifth switching element (T5") including a gate electrode configured to receive the second clock signal, a first electrode connected to a sixth node (N6"), and a second electrode connected to the seventh node; a sixth switching element (T6") including a gate electrode connected to the fifth node, a first electrode configured to receive the second clock signal, and a second electrode connected to the sixth node; a seventh switching element (T7") including a gate electrode connected to the third node, a first electrode configured to receive the gate high voltage, and a second electrode connected to the second node; an eighth switching element (T8") including a gate electrode connected to the third node, a first electrode configured to receive the first clock signal, and a second electrode connected to the fifth node; a first capacitor (C1") including a first electrode configured to receive the second clock signal and a second electrode connected to the third node; a second capacitor (C2") including a first electrode connected to the fifth node and a second electrode connected to the sixth node; and a third capacitor (C3") including a first electrode configured to receive the gate high voltage and a second electrode connected to the seventh node.

14. A display device, comprising:
a display panel (100) including a plurality of pixels;
a gate driver (300) configured to apply a gate signal to the display panel; and
a data driver (600) configured to apply a data voltage to the display panel,
wherein the gate driver is according to any one of claims 1 to 13.

15. An electronic device, comprising:
a display panel including a plurality of pixels;
a gate driver configured to apply a gate signal to the display panel;
a data driver configured to apply a data voltage to the display panel;
a driving controller configured to control the gate driver and data driver; and
a processor configured to apply input image data to the driving controller,
wherein the gate driver is according to any one of claims 1 to 13.
